# EUROPEAN PATENT APPLICATION

(11) **EP 2 557 427 A1**
(43) Date of publication of application: **13.02.2013**
(21) Application number: 10849471.7
(22) Date of filing: 09.04.2010
(51) Int. Cl.: G01R 31/28, H01L 21/822, H01L 27/04

(54) **SEMICONDUCTOR DEVICE, AND METHOD AND PROGRAM FOR TESTING SEMICONDUCTOR DEVICE**

(71) Applicant: Fujitsu Limited, Kawasaki-shi, Kanagawa 211-8588 (JP)
(72) Inventor: OOTAKE, Takashi, Kanagawa 211-8588 (JP)
(74) Representative: HOFFMANN EITLE
(86) International application number: PCT/JP2010/056485
(87) International publication number: WO 2011/125230

(57) **Abstract**

A semiconductor device has a first driving circuit to which first data is input; a first gate circuit that causes the first data that the first driving circuit outputs to pass therethrough; a first holding circuit that holds the first data that has passed through the first gate circuit; a logic circuit that carries out a logic operation on the first data that the first holding circuit outputs and outputs as second data; a second driving circuit to which the second data that the logic circuit outputs is input; a second gate circuit that causes the second data that the second driving circuit outputs to pass therethrough; a second holding circuit that holds the second data that has passed through the second gate circuit; and a power supply circuit that supplies a first voltage as a power supply voltage to the first and second gate circuits, the first and second holding circuits and the logic circuit, and supplies a second voltage higher than the first voltage as a power supply voltage to the first and second driving circuits.

## Description

### TECHNICAL FIELD

The present invention is related to a semiconductor device, and a test method and a test program for a semiconductor device.

### BACKGROUND ART

A technique is known in which an area of a semiconductor device is divided according to operation probabilities per unit time, and control of a power supply voltage (Vdd) and control of a threshold voltage (Vt) are carried out in association with the respective divided areas. According to the technique, a control target value for a threshold voltage is determined according to an operation probability. Further, a Vt control circuit controls substrate voltages of p-type and n-type MOS transistors in a semiconductor device in such a manner that a threshold voltage Vt will be kept constant to the target value without regard to a temperature variation during operation of the semiconductor device. Simultaneously, a Vdd control circuit controls a power supply voltage to the semiconductor device in such a manner that a target operation frequency will be satisfied.

### PRIOR ART REFERENCE

### PATENT REFERENCE

Patent reference No. 1: Japanese Laid-Open Patent Application No. 2005-166698
Patent reference No. 2: Japanese Laid-Open Patent Application No. 6-112782

### SUMMARY OF THE INVENTION

### PROBLEM TO BE SOLVED BY THE INVENTION

An object is to provide a semiconductor device, and a test method and a test program for a semiconductor device in which it is possible to isolate a factor of a problem and cope with the problem.

### MEANS FOR SOLVING THE PROBLEM

A semiconductor device has a first driving circuit to which a first data signal is input; and a first gate circuit through which the first data that is output from the first driving circuit passes in a case where a clock signal is applied. The semiconductor device further has a first holding circuit that holds the first data that has passed through the first gate circuit. The semiconductor device further has a logic circuit that carries out a logic operation on the first data that is output from the first holding circuit, and outputs second data. The semiconductor device further has a second driving circuit to which the second data that is output from the logic circuit is input; and a second gate circuit through which the second data that is output from the second driving circuit passes in a case where a clock signal is applied. The semiconductor device further has a second holding circuit that holds the second data that has passed through the second gate circuit. The semiconductor device further has a power supply circuit that supplies a first voltage as a power supply voltage to the first and second gate circuits, the first and second holding circuits and the logic circuit, and supplies a second voltage higher than the first voltage as a power supply voltage to the first and second driving circuits.

### ADVANTAGEOUS EFFECTS OF THE INVENTION

According to the above-mentioned semiconductor device, the power supply circuit supplies the second voltage higher than the first voltage as the power supply voltage to the first and second driving circuits. As a result, it is possible to avoid a problem that will be described now. That is, when the change in the voltage level on the output side of the first driving circuit in response to the first data is insufficient, the state of holding the first data in the first holding circuit is not maintained. Thus, the first data is not transferred to the subsequent logic circuit. When the first data is not transferred to the logic circuit, there may be a case where it is erroneously determined that the semiconductor device has a signal transfer delay problem. By supplying the second voltage higher than the first voltage as the power supply voltage to the first driving circuit as mentioned above, the change in the voltage level on the output side of the first driving circuit in response to the first data will become sufficiently large. As a result, the state of holding the first data in the first holding circuit is maintained, and thus, transfer of the first data to the subsequent logic circuit is positively carried out. As a result, it will not be erroneously determined that the semiconductor device has a signal transfer delay problem.

Similarly, when the change in the voltage level on the output side of the second driving circuit in response to the second data that is output by the logic circuit is insufficient, the state of holding the second data in the second holding circuit is not maintained. When the state of holding the second data in the second holding circuit is not maintained, there may be a case where it is erroneously determined that the semiconductor device has a signal transfer delay problem. By supplying the second voltage higher than the first voltage as the power supply voltage to the second driving circuit as mentioned above, the change in the voltage level on the output side of the second driving circuit in response to the second data that is output by the logic circuit will become sufficiently large. As a result, the state of holding the second data in the second holding circuit is positively maintained. As a result, it will not be erroneously determined that the semiconductor device has a signal transfer delay problem.

### BRIEF DESCRIPTION OF DRAWINGS

FIG. 1 is a circuit diagram for illustrating a transfer of a data signal between latch circuits that are provided before and after a logic circuit.
FIG. 2 is a circuit diagram depicting an internal configuration example of each latch circuit depicted in FIG. 1.
FIG. 3 is a time chart illustrating a transfer of a data signal between latch circuits that are provided before and after a logic circuit.
FIG. 4 is a circuit diagram illustrating a case where an embodiment 1 is applied to the circuit configuration depicted in FIG. 1.
FIG. 5 is a circuit diagram (No. 1) depicting an internal configuration example of each latch circuit depicted in FIG. 4.
FIG. 6 is a circuit diagram (No. 2) depicting an internal configuration example of each latch circuit depicted in FIG. 4.
FIG. 7 is a circuit diagram illustrating operations of the latch circuit depicted in FIG. 6.
FIG. 8 is a time chart illustrating operations of the latch circuit depicted in FIG. 6.
FIG. 9 is a circuit diagram illustrating a case where an embodiment 2 is applied to the circuit configuration depicted in FIG. 1.
FIG. 10 is a circuit diagram (No. 1) depicting an internal configuration example of each latch circuit depicted in FIG. 9.
FIG. 11 is a circuit diagram (No. 2) depicting an internal configuration example of each latch circuit depicted in FIG. 9.
FIG. 12 is a circuit diagram illustrating operations of the latch circuit depicted in FIG. 11.
FIG. 13 is a circuit diagram of a LSI according to an embodiment 3.
FIG. 14 illustrates a connection between a LSI and a LSI tester.
FIG. 15 is a flowchart illustrating a flow of a LSI test.
FIG. 16 is a flowchart (No. 1) illustrating a flow of a function test in the flowchart of FIG. 15.
FIG. 17 is a circuit diagram of a LSI according to an embodiment 4.
FIG. 18 is a flowchart (No. 2) illustrating a flow of a function test in the flowchart of FIG. 15.
FIG. 19 is a block diagram depicting a hardware configuration example of a LSI tester depicted in FIG. 14.

### MODE OF CARRYING OUT THE INVENTION

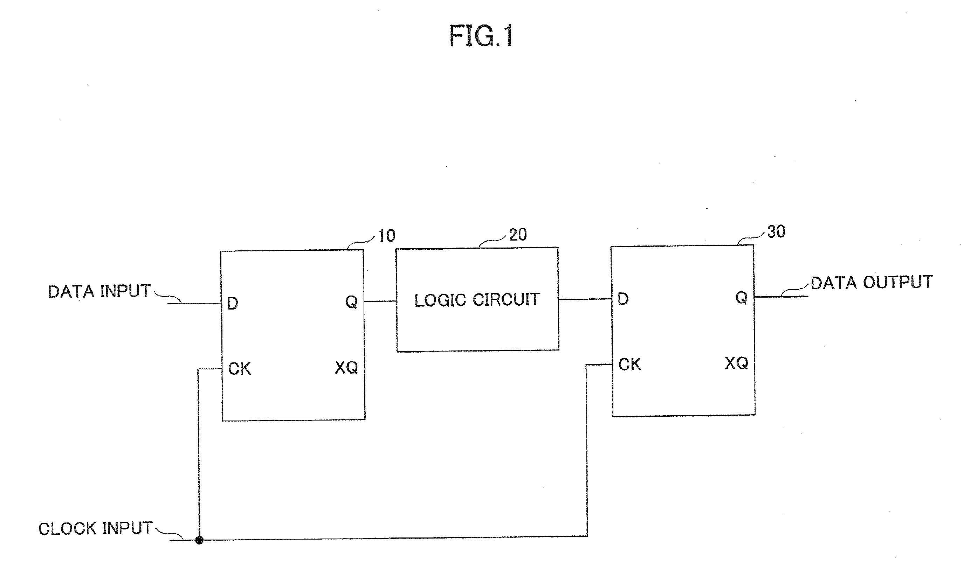

With FIG. 1, a data transfer in a semiconductor device that is included in a LSI (Large Scale Integrated circuit) will be described. FIG. 1 depicts a circuit of transferring data. The circuit of transferring data has a logic circuit 20, a latch circuit 10 on the input side and a latch circuit 30 on the output side of the logic circuit 20.

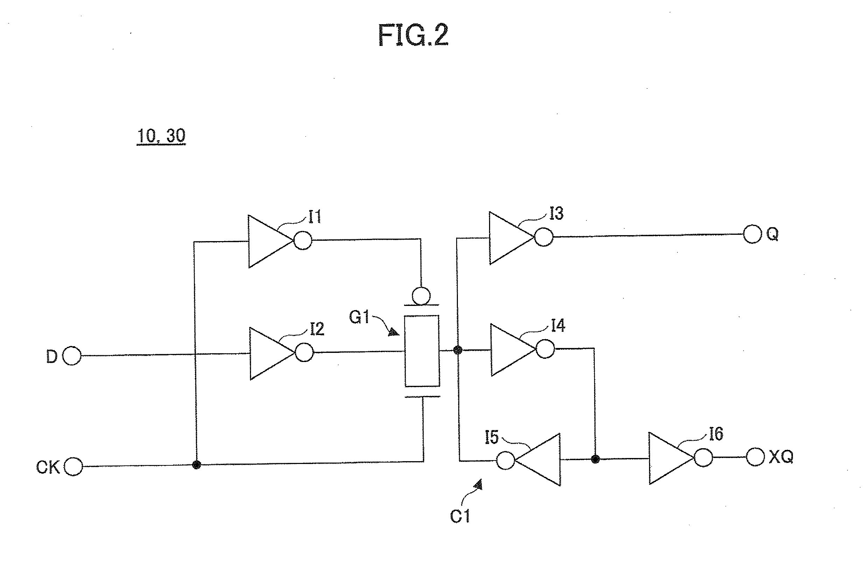

FIG. 2 depicts an internal configuration example of each of the above-mentioned latch circuits 10 and 30. Each of the latch circuits 10 and 30 has an inverter circuit I2 as a driving circuit of inverting a signal and driving the inverted signal; and a transmission gate circuit G1. The transmission gate circuit G1 functions as a gate circuit (a pair of pass transistor circuits) which is opened and closed by a clock signal given to a clock input terminal CK, and causes an output value of the inverter circuit I2 to pass therethrough when it is opened. That is, the transmission gate circuit G1 enters an opened state in a case where the clock signal given to the clock input terminal CK has a High level, and enters a closed state in a case of a Low level. Thus, the transmission gate circuit G1 controls a passage of a signal. Each of the latch circuits 10 and 30 further has inverter circuits I4 and I5 which form a holding circuit C1 that holds the voltage level that is the output value of the inverter circuit I2 having passed through the transmission gate circuit G1. Each of the latch circuits 10 and 30 further has an inverter circuit I1 that inverts the clock signal and gives it to the transmission gate circuit G1; and an inverter circuit I3 that inverts the value of the input side of the holding circuit C1 (I4 and I5) and outputs it. Each of the latch circuits 10 and 30 further has an inverter circuit I6 that inverts the value of the output side of the holding circuit C1 and outputs it.

Each of the latch circuits 10 and 30 having this configuration has a data input terminal D, the clock input terminal CK and a data output terminal Q. In each of the latch circuit 10 and 30, a value of a data signal given to the data input terminal D is output from the data output terminal Q while the clock signal given to the clock input terminal CK has the H level. On the other hand, while the clock signal has the L level, a data signal given to the data input terminal D is cut off, the value of the data signal is not output from the data output terminal Q, and the data output terminal holds the immediately preceding value. Thus, the output value of each of the latch circuits 10 and 30 may change only while the clock signal has the H level.

Operations of each of the latch circuits 10 and 30 will now be described in more detail.
When a data signal is input to the data input terminal D, the value of the data signal is inverted by the inverter circuit I2, and is output to the transmission gate circuit G1. The transmission gate circuit G1 is in the opened state while the clock signal that is input to the clock input terminal CK has the H level, and causes the output of the inverter circuit I2 to pass therethrough. The output of the inverter circuit I2 having passed through the transmission gate circuit G1 is given to the holding circuit C1 which then holds the value of the thus given output of the inverter circuit I2. The value thus held by the holding circuit C1 is output from respective data output terminals Q and XQ via the inverter circuits I3 and I6.

As one of tests using a LSI tester to determine whether a LSI is satisfactory, a WDFT (double clock dynamic function test) test is known. The WDFT test is a sort of a timing test. In the WDFT test, by applying a first clock signal, a data signal that is input to a LSI from a LSI tester is input to a first latch that is a transmission source. Then, it is determined whether, by further applying a second clock signal, the above-mentioned data signal that the first latch has output by taking in it can be taken in by a second latch that is a reception destination. Thus, it is determined whether the LSI is satisfactory.

In a case where the WDFT test is carried out on the circuit of FIG. 1, when a data signal is input to the data input terminal D of the latch circuit 10, the latch circuit 10 causes the data signal to pass therethrough, and input it to the logic circuit 20. The logic circuit 20 carries out a predetermined logic operation on the value of the data signal that is input from the latch circuit 10, and outputs the value of the result of the logic operation. The operation result of the logic circuit 20 is output via the latch circuit 30. The operation of the logic circuit 20 may also be a data transfer operation of transferring an input value as an output value without changing it using a buffer circuit(s) and/or (an even number of) inverter circuits. By using the WDFT test, it is verified that the data transfer operation of the logic circuit 20 between the latch circuits 10 and 30 can be carried out within a predetermined signal transfer delay time.

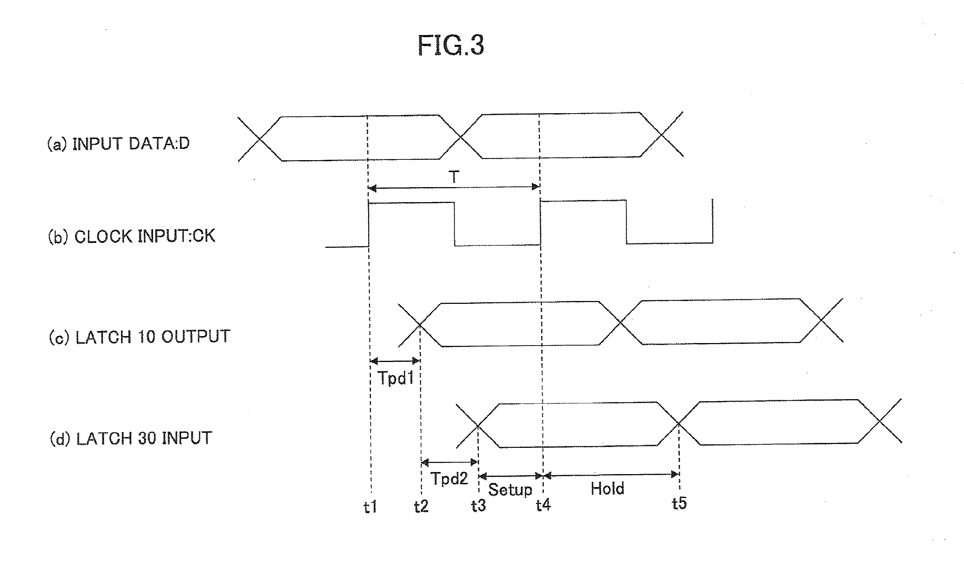

FIG. 3 depicts a time chart of the data transfer operation between the latch circuit 10 and the latch circuit 30. FIG. 3 (a) depicts the waveform of the data signal that is input to the latch circuit 10. FIG. 3 (b) depicts the waveform of the clock signal that is applied to the latch circuit 10. FIG. 3 (c) depicts the waveform of the data signal that is output from the data output terminal Q of the latch circuit 10. FIG. 3 (d) depicts the waveform of the data signal at the data input terminal D of the latch circuit 30. As depicted in FIG. 3, in the above-mentioned data transfer operation between the latch circuits, the clock signal has the H level at a time t1, and as a result, the latch circuit 10 takes in the value of the data signal that is input to the data input terminal D. Then, at a time t2, the value of the data signal that is thus taken in is output from the latch circuit 10.

The time Tpd1 between the times t1 and t2 indicates the delay time of the latch circuit 10. During the time Tpd1, the clock signal has the H level, the value of the data signal is taken in from the data input terminal D in FIG. 2, is caused to pass through the transmission gate circuit G1, is held by the holding circuit C1 and is output from the data output terminal Q. Further, the time Tpd2 between times t2 and t3 indicates the delay time of the logic circuit 20. During the time Tpd2, the logic circuit 20 carries out the predetermined logic operation based on the output of the latch circuit 10, and the value of the logic operation result reaches the data input terminal D of the latch circuit 30.

Further, the time between times t3 and t4 is the setup time Setup of the latch circuit 30.
The setup time means the minimum time during which the logic circuit 20 is required to previously output the data signal to the latch circuit 30 before the clock signal that is a timing signal is input, when the latch circuit 30 will take in the value of the input data signal as a result of the clock signal being applied. Further, the time between times t4 and t5 is the hold time Hold of the latch circuit 30. The hold time means the minimum time during which the latch circuit 30 is required to continuously hold the data signal that the latch circuit 30 has held, after the clock signal that is the timing signal is applied, when the latch circuit 30 will output the value of the data signal as a result of the clock signal being applied.

As a shipping test for a LSI, an ATPG (Automatic Test Pattern Generation) test and the above-mentioned WDFT test are carried out. The ATPG test is a shipping test that is carried out on a manufactured LSI using a test pattern. The test pattern is generated, for the LSI to be tested, automatically based on logics of circuits of the LSI and binding conditions and/or the like of input signals for the circuits. By the ATPG test and WDFT test, it is possible to test as to whether there is a problem of electric characteristics for when the LSI takes in data by a latch circuit, a permanent fault of a logical path, or a signal transfer delay problem.

In the WDFT test, many latch circuits are caused to operate simultaneously, using a clock signal having a frequency equal to a frequency of system operations oscillated by a PLL (Phase Locked Loop) or a ROSC (Ring OSCillator) included in the LSI. Thus, the test may be easily influenced by power-supply noise. In a case of having been influenced by power-supply noise, the power supply voltage may fall, and there may be a case where data cannot be properly taken in by the latch circuit 30 in FIG. 2. In this case, the LSI tester may erroneously determine that a signal transfer delay problem has occurred even though a signal transfer has been properly carried out by the logic circuit 20 in FIG. 2. That is, in a case where the LSI fails in the WDFT test using the LSI tester (i.e., a problem has been detected), it is determined that the LSI has a signal transfer delay problem. However, actually, there may be a case where the power supply voltage falls as having been influenced by power-supply noise, and a voltage for which the LSI fails in the ATPG test, i.e., a fact that the power supply voltage falls to less than a data taking-in characteristic limit voltage, is the factor. In this case, the power supply voltage falls to less than the data taking-in characteristic limit voltage of the latch circuit due to power-supply noise, and thus, the LSI fails in the WDFT test.

For example, it is assumed that a logical path in which the data taking-in characteristic limit voltage of a latch circuit is less than or equal to 0.7 V is included in a LSI, and the logical path fails in the WDFT test of the power supply voltage of 0.8 V. In this case, actually, there is a possibility that the above-mentioned power supply voltage of 0.8 V falls to the above-mentioned 0.7 V as having been influenced by power-supply noise, and as a result, the LSI has failed due to the data taking-in characteristics of the latch circuit. In this case, it is determined that a signal transfer delay problem has occurred since the LSI has failed in the WDFT test although the LSI has failed actually due to the data taking-in characteristics of the latch circuit.

A method may be considered to increase the power supply voltage of the LSI, and thus compensate the fall of the power supply voltage due to the power-supply noise. However, to increase the power supply voltage of a LSI is not preferable because of a recent request for power saving.

According to each embodiment described below, in a case where a problem has been detected in a LSI, it is possible to correctly determine whether the factor of the detected problem is a signal transfer delay problem which is a primary detection target of the WDFT test or a problem concerning the data taking-in characteristics of a latch circuit.

According to the respective embodiments described below, concerning a power supply voltage (embodiment 1) or a substrate bias voltage (embodiment 2) of transistors, the power supply is separated into power supply to driving circuits that output signals to holding circuits via gate circuits and power supply to the other circuits, in latch circuits that are provided on the input side and the output side of a logic circuit.

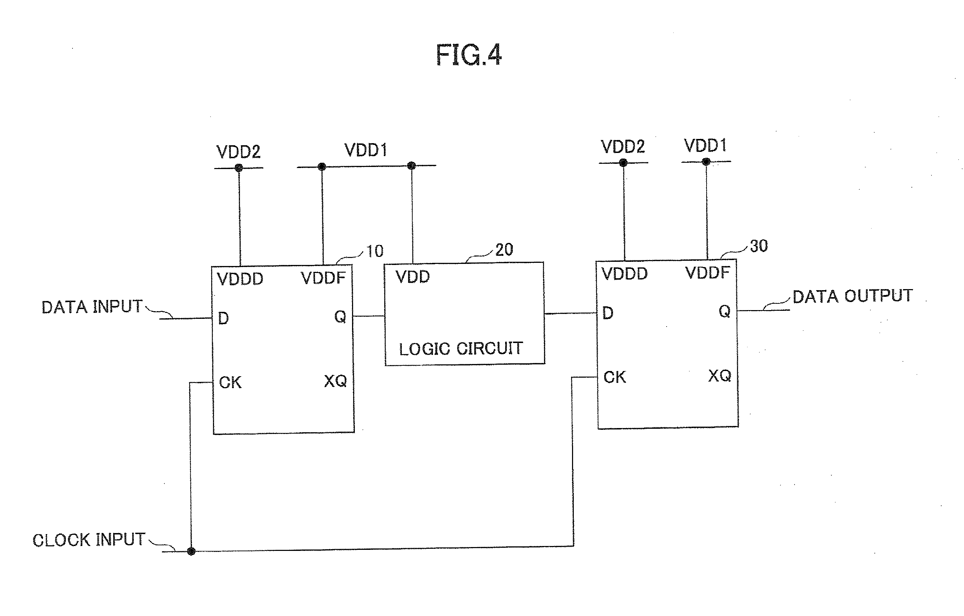

Below, with FIGs. 4, 5 and 6, a circuit configuration of a semiconductor device according to the embodiment 1 will be described.

As depicted in FIG. 4, the semiconductor device has a logic circuit 20, and a latch circuit 10 on the input side and a latch circuit 30 on the output side of the logic circuit 20. A power supply voltage VDD1 and a power supply voltage VDD2 are supplied to the latch circuits 10 and 30, and the power supply voltage VDD1 is supplied to the logic circuit 20. Further, a data signal is input to a data input terminal D of the latch circuit 10 and a clock signal is input to clock input terminals CK of the latch circuits 10 and 30.

Operations of the circuit of FIG. 4 will now be described. The latch circuit 10 takes in the value of the data signal that is input to the data input terminal D while the clock signal that is input to the clock input terminal CK has a H level, and the latch circuit 10 outputs it from the data output terminal Q. The logic circuit 20 carries out a predetermined logic operation according to the output at the data output terminal Q of the latch circuit 10, and outputs the value of the logic operation result. The output of the logic circuit 20 is input to the data input terminal D of the latch circuit 30. The latch circuit 30 takes in the value of the data signal that is input to the data input terminal D while the clock signal that is input to the clock input terminal CK has the H level, and the latch circuit 30 outputs it from the data output terminal Q.

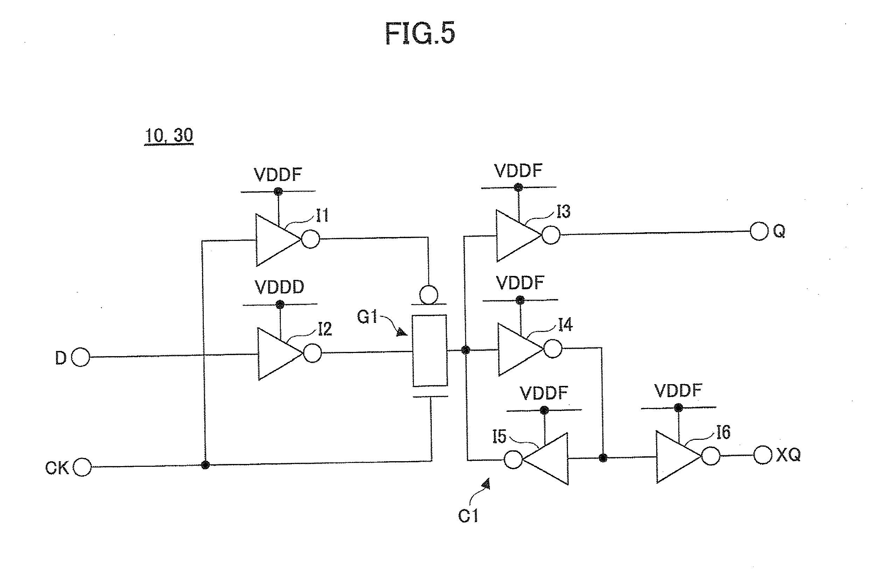

FIG. 5 depicts an internal circuit of each of the latch circuits 10 and 30. That is, each of the latch circuits 10 and 30 has an inverter circuit I1 as a driving circuit that inverts the clock signal; and an inverter circuit I2 that inverts the data signal, and drives the inverted signal. Further, each of the latch circuits 10 and 30 has a transmission gate (pass transistor) circuit G1 as a gate circuit that causes the output of the inverter circuit I2 to pass therethrough at a timing of the clock signal and the signal inverted from the clock signal. Further, each of the latch circuits 10 and 30 has inverter circuits I4 and I5 that form a holding circuit C1 that holds the value of the output that has passed through the transmission gate circuit G1; and inverter circuits I3 and I6 that output the value held by the holding circuit C1 (I4 and I5). As depicted in FIG. 5, a power supply voltage VDDD is supplied to the inverter circuit I2 as the driving circuit that inverts the signal and drives the inverted signal, and a power supply voltage VDDF is supplied to the other inverter circuits I1, I3, I4, I5 and I6 and the transmission gate circuit G1. Further, as depicted in FIG. 4, the power supply voltage VDDF is equal to the power supply voltage VDD1, and the power supply voltage VDDD is equal to the power supply voltage VDD2.

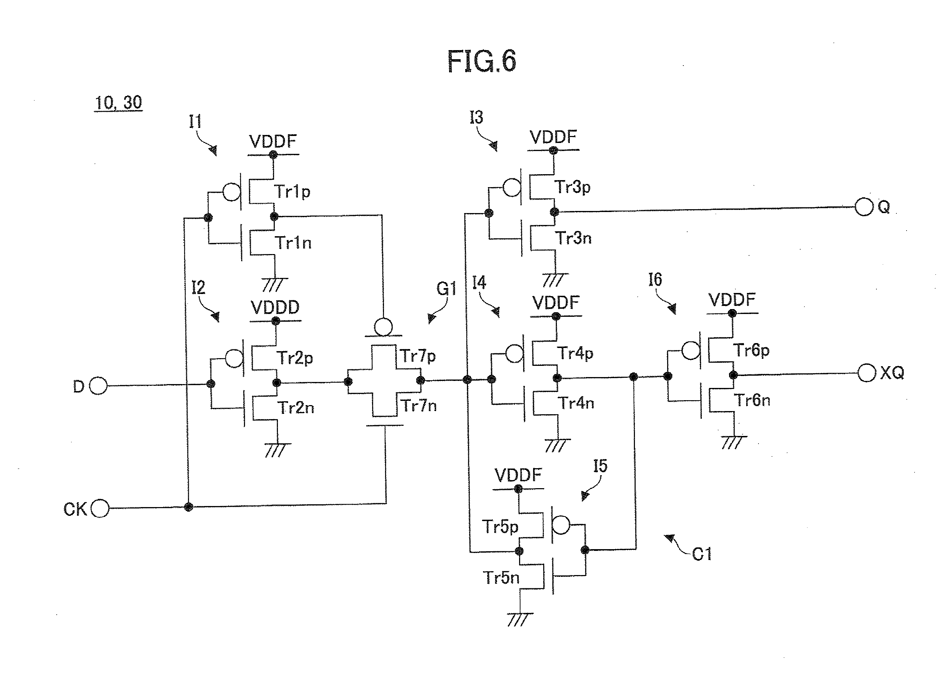

FIG. 6 corresponds to the circuit of FIG. 5, and is a circuit on a transistor level. In FIG. 6, a p-channel MOSFET (p-channel Metal Oxide Semiconductor Field Effect Transistor) Tr1p and an n-channel MOSFET (n-channel Metal Oxide Semiconductor Field Effect Transistor) Tr1n form the inverter I1. Similarly, a p-channel MOSFET Tr2p and an n-channel MOSFET Tr2n form the inverter I2, and a p-channel MOSFET Tr3p and an n-channel MOSFET Tr3n form the inverter I3. Similarly, a p-channel MOSFET Tr4p and an n-channel MOSFET Tr4n form the inverter I4, and a p-channel MOSFET Tr5p and an n-channel MOSFET Tr5n form the inverter I5. Similarly, a p-channel MOSFET Tr6p and an n-channel MOSFET Tr6n form the inverter I6. Thus, each of the inverter circuits I1, I2, I3, I4, I5 and I6 has a CMOS (Complementary Metal Oxide Semiconductor) structure including the p-channel MOSFET and n-channel MOSFET. Further, a p-channel MOSFET Tr7p and an n-channel MOSFET Tr7n form the transmission gate circuit G1.

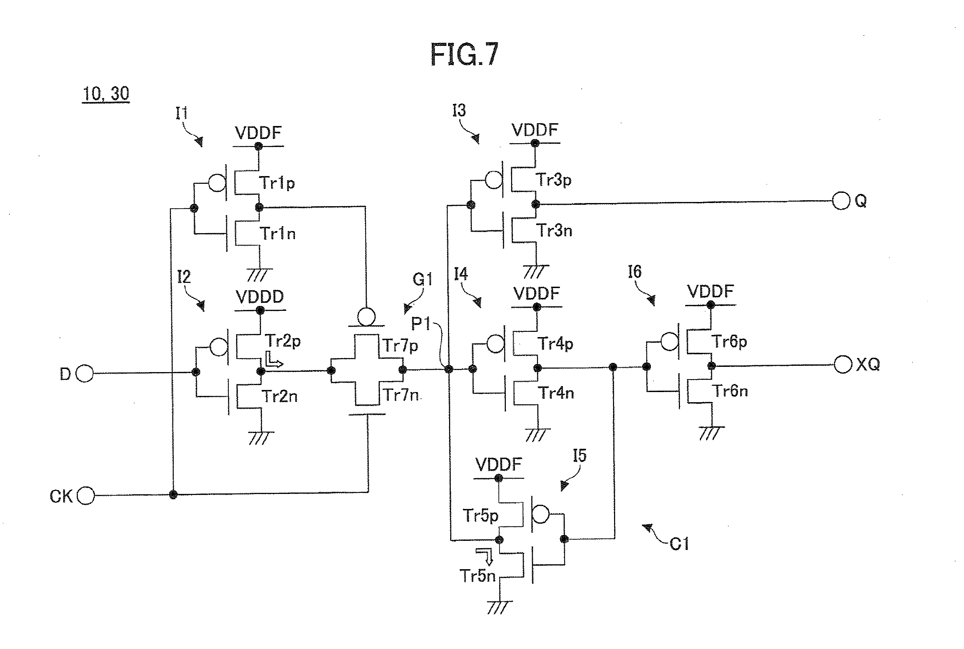

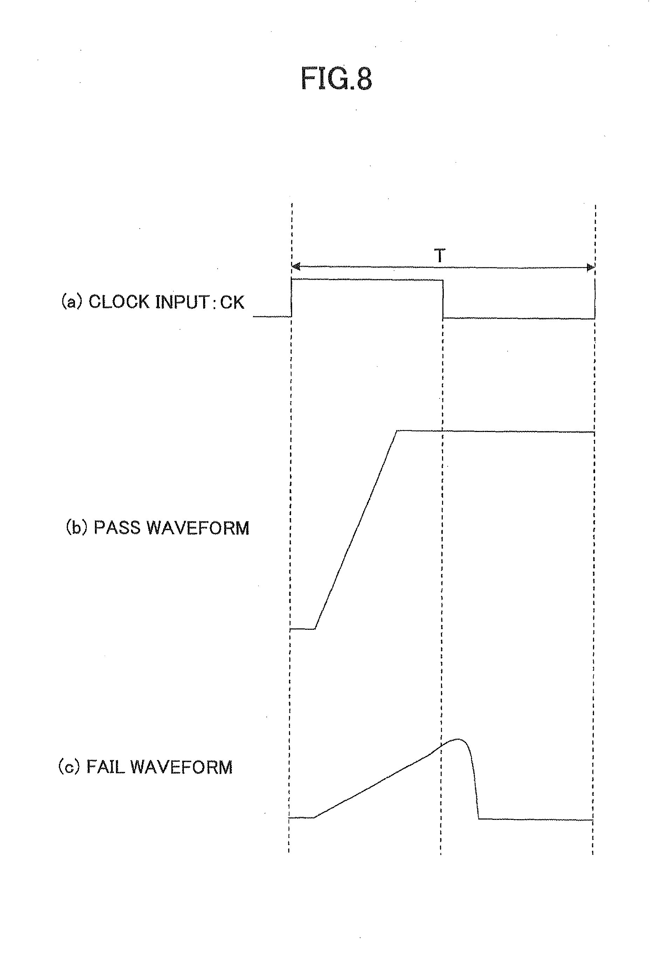

Next, a case where the WDFT test is carried out on the semiconductor device described above with FIGs. 4, 5 and 6 will be described. First, it is assumed that as a result of the WDFT test being carried out with the power supply voltage VDD1 and the power supply voltage VDD2 having been set to the same voltage, the semiconductor device has failed. In this case, it is assumed that as a result of the WDFT test being again carried out with only the power supply voltage VDD2 having been set higher, the semiconductor device has passed. The above-mentioned "with only the power supply voltage VDD2 having been set higher" means a state in which the voltage VDD1 is fixed, and the VDD2 is made higher than VDD1. In such a case, it can be determined that the factor of the above-mentioned failure is not a signal transfer delay problem but a data taking-in characteristic failure of at least any one of the latch circuits 10 and 30. This point will be described in more detail with FIGs. 7 and 8.

FIG. 7 is a circuit diagram of a transistor level the same as FIG. 6, and depicts an internal circuit configuration example of the latch circuit 30. It is noted that the data taking-in characteristics of the latch circuit 30 are determined by a relationship between a function of reflecting the value of the input signal by the driving capability of the inverter circuit I2 that drives the signal and a function of maintaining the immediately preceding state by the driving capability of the inverter circuit I5 for a feedback of one of the holding circuit C1.

FIG. 8 (a) through (c) depicts timing charts for one cycle of the clock signal. FIG. 8 (a) depicts a waveform of the clock signal. FIG. 8 (b) and FIG. 8 (c) depict voltage waveforms at an output node P1 of the transmission gate circuit G1 in a case where in FIG. 7, the value of the data signal that is input to the data input terminal D changes from the H level to the L level. FIG. 8 (b) depicts a waveform example for a case where the semiconductor device passes in the WDFT test, and FIG. 8 (c) depicts a waveform example for a case where the semiconductor device fails in the WDFT test.

When the WDFT test is carried out on the circuit of FIG. 4, a data signal is input to the data input terminal D of the latch circuit 10, the logic circuit 20 carries out a logical operation, and the value of the logical operation result is input to the latch circuit 30. In the latch circuit 30 depicted in FIG. 7, the immediately preceding state of the latch circuit 30 indicates a state in which the value of the data signal that is input to the data input terminal D has the H level. That is, the H level is inverted by the inverter circuit I2 into the L level, and the L level is output to the output node P1 via the transmission gate circuit G1. The inverter circuit I4 of the holding circuit C1 inverts the L level into the H level, and the inverter circuit I5 for a feedback of the holding circuit C1 gives the L level obtained from inverting the H level to the output node P1. Thus, in the immediately preceding state, the output node P1 has the L level.

When the value of the data signal that is input to the data input terminal D is changed from the H level into the L level in the latch circuit 30 depicted in FIG. 7, the L level is inverted by the inverter circuit I2 into the H level. The H level is caused to pass through the transmission gate circuit G1 while the clock signal has the H level, and changes the output node P1 into the H level. At this time, as mentioned above, in the immediately preceding state, the inverter circuit I5 for a feedback of the holding circuit C1 outputs the L level to the output node P1, and has a function of connecting the output node P1 to the ground side, as indicated by an arrow in FIG. 7, and maintaining the voltage of the output node P1 at the L level. FIG. 8 (b) depicts a case where the function of reflecting the value of the input signal by the driving capability of the inverter circuit I2 is greater than the function of maintaining the voltage of the output node P1 at the L level by the driving capability of the inverter circuit I5 for a feedback of the holding circuit C1. It is noted that as depicted in FIG. 7 and so forth, the power supply voltage VDDD is applied to the inverter circuit I2 instead of the power supply voltage VDDF. In this case, as depicted in FIG. 8 (b), the voltage of the output node P1 is sufficiently increased while the clock signal has the H level depicted in FIG. 8 (a). As a result, in the holding circuit C1, the p-channel MOSFET Tr4p of the inverter circuit I4 is turned off and the n-channel MOSFET Tr4n is turned on by the H level of the output node P1. As a result, the output of the inverter I4 becomes the L level. Then, as a result of the L level being input, the p-channel MOSFET Tr5p of the inverter circuit I5 for a feedback is turned on and the n-channel MOSFET Tr5n is turned off. As a result, the value of the H level is output from the inverter circuit I5. Thus, the holding circuit C1 is changed into the state corresponding to the value of the output of the inverter circuit I2, and thus, can take in the value of the data signal. As a result, the semiconductor device passes in the WDFT test.

On the other hand, FIG. 8 (c) depicts a case where the function of maintaining the voltage of the output node P1 at the L level by the driving capability of the inverter circuit I5 for a feedback of the holding circuit C1 is greater than the function of reflecting the value of the input signal by the driving capability of the inverter circuit 12. In this case, as depicted in FIG. 8 (c), the voltage of the output node P1 cannot be sufficiently increased while the clock signal has the H level depicted in FIG. 8 (a). As a result, in the holding circuit C1, the on state of the p-channel MOSFET Tr4p of the inverter circuit I4 is maintained as it has been and the off state of the n-channel MOSFET Tr4n is maintained as it has been. As a result, the output of the inverter circuit I4 is maintained at the H level. Thus, the p-channel MOSFET Tr5p of the inverter circuit I5 for a feedback is maintained in the off state as it has been and the n-channel MOSFET Tr5n is maintained in the on state as it has been. Thus, the output of the inverter circuit I5 is maintained at the L level. Thus, while the clock signal has the H level, the holding circuit C1 is maintained in the immediately preceding state. Thus, the holding circuit C1 cannot be changed into the state corresponding to the value of the output of the inverter circuit I2 while the clock signal has the H level. When the clock signal comes to have the L level in this state, the transmission gate circuit G1 is closed, and the output of the inverter 12 is cut off. As a result, the voltage of the output node P1 has the L level that is the output of the inverter circuit I5 for a feedback of the holding circuit C1, and thus, the latch circuit 30 cannot take in the value of the data signal. Thus, the data transfer operation is not completed during the predetermined signal transfer delay time, and the WDFT test results in failure.

In a case where the WDFT test has thus resulted in failure (the case of FIG. 8 (c)), the WDFT test is again carried out with only the power supply voltage VDD2 made higher. "With only the power supply voltage VDD2 made higher" corresponds to a state in which the voltage of VDD1 is fixed, and VDD2 is made higher than VDD1. Thus, the power supply voltage VDDD is set higher than VDDF. As a result, in FIG. 7, the power supply voltage of the inverter circuit I2 is increased, and the driving capability of the inverter circuit I2 is increased. As a result, the state of FIG. 8 (b). That is, the driving capability of the inverter circuit I2 becomes greater than the function of maintaining the voltage of the output node P1 at the L level by the inverter circuit I5 for a feedback of the holding circuit C1. It is noted that as mentioned above, to the inverter I2, the power supply voltage VDDD is applied instead of the power supply voltage VDDF.
As a result, the voltage at the output node P1 is sufficiently increased while the clock signal has the H level, the holding circuit C1 is changed into the state corresponding to the value of the output of the inverter circuit I2, and the latch circuit 30 can take in the value of the data signal. Thus, in a case where the semiconductor device does not have a signal transfer delay problem, and the WDFT test results in failure due to power-supply noise, the WDFT test is carried out again with only the power supply voltage VDD2 increased. "With only the power supply voltage VDD2 increased" means a state in which the voltage of VDD1 is fixed, and VDD2 is made higher than VDD1. When the latch circuit 30 can take in the value of the data signal consequently, it is possible to determine that the semiconductor device does not have a signal transfer delay problem.

On the other hand, in a case where the semiconductor device actually has a signal transfer delay problem, the latch circuit 30 still cannot take in the value of the data signal even when the WDFT test has been carried out again with only the power supply voltage VDD2 increased. "With only the power supply voltage VDD2 increased" means a state in which the voltage of VDD1 is fixed, and VDD2 is made higher than VDD1. In this case, it is possible to determine that the semiconductor device has a signal transfer delay problem. Thus, according to the embodiment 1, even when a variation in the power supply voltage due to power-supply noise exists, it is possible to positively determine whether the factor by which the semiconductor device fails in the WDFT test is a signal transfer delay problem.

Further, in a case where it has been determined that as mentioned above, the semiconductor device does not have a signal transfer delay problem, and the WDFT test results in failure due to power-supply noise, the LSI may be shipped with only the power supply voltage VDD2 increased. "With only the power supply voltage VDD2 increased" means a state in which the voltage of VDD1 is fixed, and VDD2 is made higher than VDD1. That is, the LSI may be shipped in the state in which the latch circuit 30 can take in a value of a data signal even with the power supply voltage falling due to power-supply noise. As a result, in comparison to a case where shipping is carried out with the entire power supply voltage including VDD1 and VDD2 set higher, it is possible to achieve power saving of the product. Further, in a case where, conversely, it has been determined that the semiconductor device actually has a signal transfer delay problem, the LSI is shipped with only the power supply voltage VDD1 increased. "With only the power supply voltage VDD1 increased" means a state in which the voltage of VDD2 is fixed, and VDD1 is made higher than VDD2. That is, the LSI is shipped with the power supply voltage of the transistors of the latch circuits 10 and 30 other than the inverter circuits I2 set higher. The driving capabilities of the transistors for which the power supply voltage is increased are increased, and the operation speeds are increased. As a result, it is possible to solve the signal transfer delay problem. As a result, in comparison to a case where shipping is carried out with the entire power supply voltage including VDD1 and VDD2 set higher, it is possible to achieve power saving of the product.

Thus, according to the embodiment 1, the power system (VDDD) of the transistors of the inverter circuits I2 of the latch circuits 10 and 30 provided on the input and output sides of the logic circuit 20 included in the semiconductor device is separated from the power supply system (VDDF) of the other transistors. Then, when the WDFT test is carried out, the power supply voltage (VDDD) of the inverter circuits I2 included in the latch circuits 10 and 30 is adjusted separately from the power supply voltage (VDDF) of the other transistors. As a result, in a case where the semiconductor device has a problem, it is possible to easily determine whether the problems have occurred due to a signal transfer delay problem between the latch circuits 10 and 30 or a problem concerning the data taking-in characteristics of the latch circuits 10 and 30. Further, it is possible to solve the problem in an appropriate manner according to the determination result.

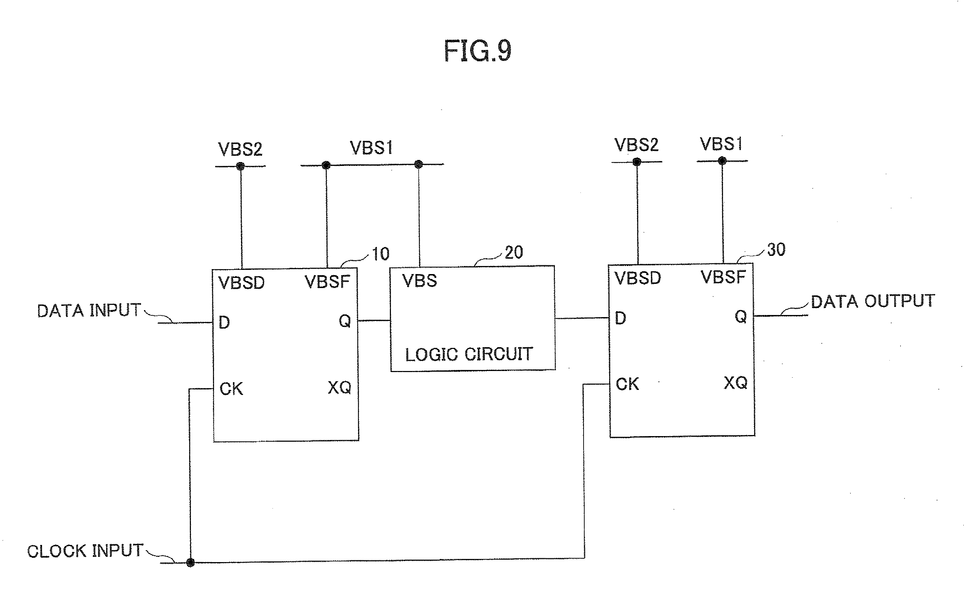

Below, with FIGs. 9, 10 and 11, a circuit configuration of a semiconductor device according to the embodiment 2 will be described.

As depicted in FIG. 9, the semiconductor device according to the embodiment 2 has a logic circuit 20, a latch circuit 10 on the input side and a latch circuit 30 on the output circuit of the logic circuit 20. To the latch circuits 10 and 30, a substrate bias voltage VBS1 and a substrate bias voltage VBS2 are supplied. A substrate bias voltage means a voltage applied to a substrate of a MOS (Metal Oxide Semiconductor) integrated circuit such as the semiconductor device of the embodiment 2. To the logic circuit 20, the substrate bias voltage VBS1 is supplied. It is noted that in the circuit of FIG. 9, a usual power supply voltage (for example, VDD1 mentioned above with FIG. 4) is supplied.

Operations of the circuit of FIG. 9 will now be described. A data signal is input to a data input terminal D of the latch circuit 10, and a clock signal is input to a clock input terminal CK. The latch circuit 10 takes in the value of the data signal that is input to the data input terminal D while the clock signal that is input to the clock input terminal CK has a H level, and the latch circuit 10 outputs it from the data output terminal Q. The logic circuit 20 carries out a predetermined logic operation according to the output at the data output terminal Q of the latch circuit 10, and outputs the value of the logic operation result.
The output of the logic circuit 20 is input to the data input terminal D of the latch circuit 30. The latch circuit 30 takes in the value of the data signal that is input to the data input terminal D while the clock signal that is input to the clock input terminal CK has the H level, and the latch circuit 30 outputs it from the data output terminal Q.

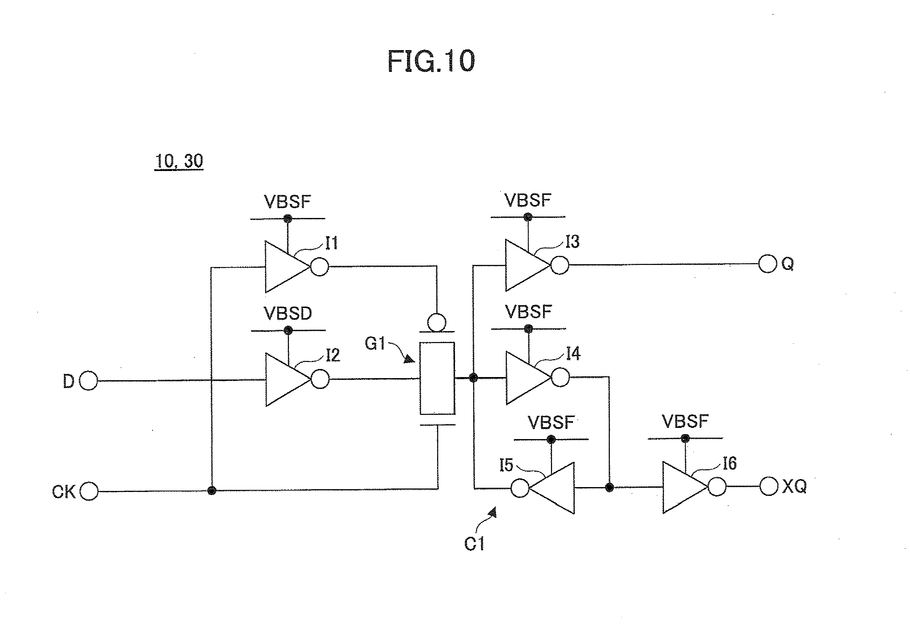

Each of the latch circuits 10 and 30 has a circuit configuration depicted in FIG. 10. That is, each of the latch circuits 10 and 30 has an inverter circuit I1 that inverts the clock signal; and an inverter circuit I2 as a driving circuit that inverts the data signal, and drives the inverted signal in addition to inverting the signal. Further, each of the latch circuits 10 and 30 has a transmission gate circuit G1 as a gate circuit which causes the output of the inverter circuit 12 to pass therethrough at a timing of the clock signal and the signal inverted from the clock signal. Further, each of the latch circuits 10 and 30 has inverter circuits I4 and I5 that form a holding circuit C1 that holds the value of the output that has passed through the transmission gate circuit G1; and inverter circuits I3 and I6 that output the value held by the holding circuit C1 (I4 and I5).

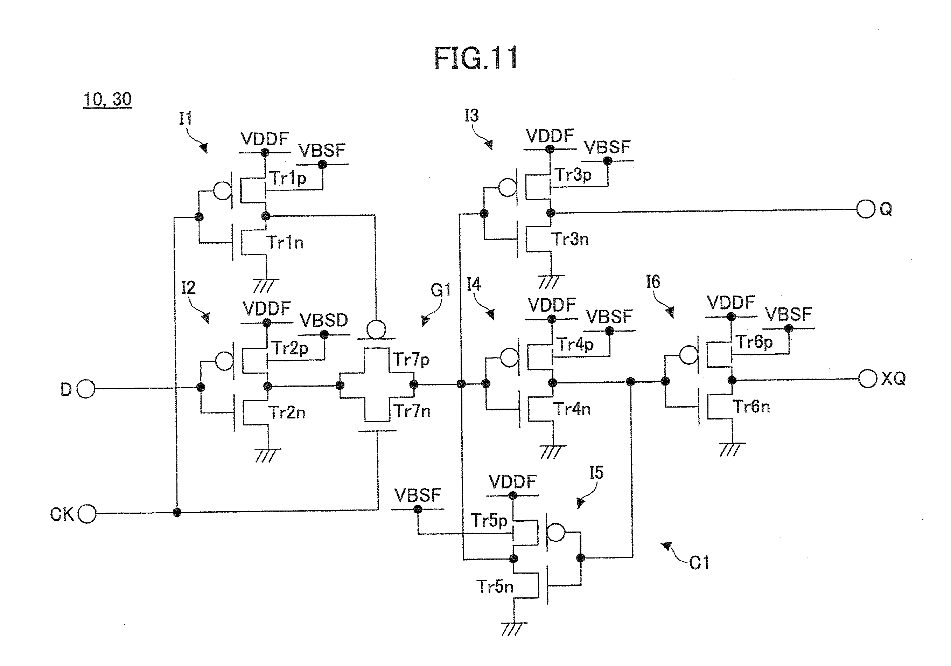

Further, as depicted in FIG. 11, to a p-channel MOSFET Tr2p of the inverter circuit I2 as the driving circuit of inverting the signal and driving the inverted signal, a substrate bias voltage VBSD is supplied, and a substrate bias voltage VBSF is supplied to the p-channel MOSFETs Tr1p, Tr3p, Tr4p, Tr5p, Tr6p and Tr7p of the other inverter circuits I1, I3, I4, I5 and I6 and the transmission gate circuit G1. As depicted in FIG. 9, the substrate bias voltage VBSF is equal to the substrate bias voltage VBS1, and the substrate bias voltage VBSD is equal to the substrate bias voltage VBS2. It is noted that the above-mentioned power supply voltage VDDF, for example, is supplied to the respective transistors of the inverter circuit I2 as the driving circuit of inverting the signal and driving the inverted signal, the other inverter circuits I1, I3, I4, I5 and I6 and the transmission gate circuit G1 (see FIG. 11 described later). Further, as depicted in FIG. 11, each of the inverter circuits I1, I2, I3, I4, I5 and I6 has a CMOS structure including the p-channel MOSFET and the n-channel MOSFET.

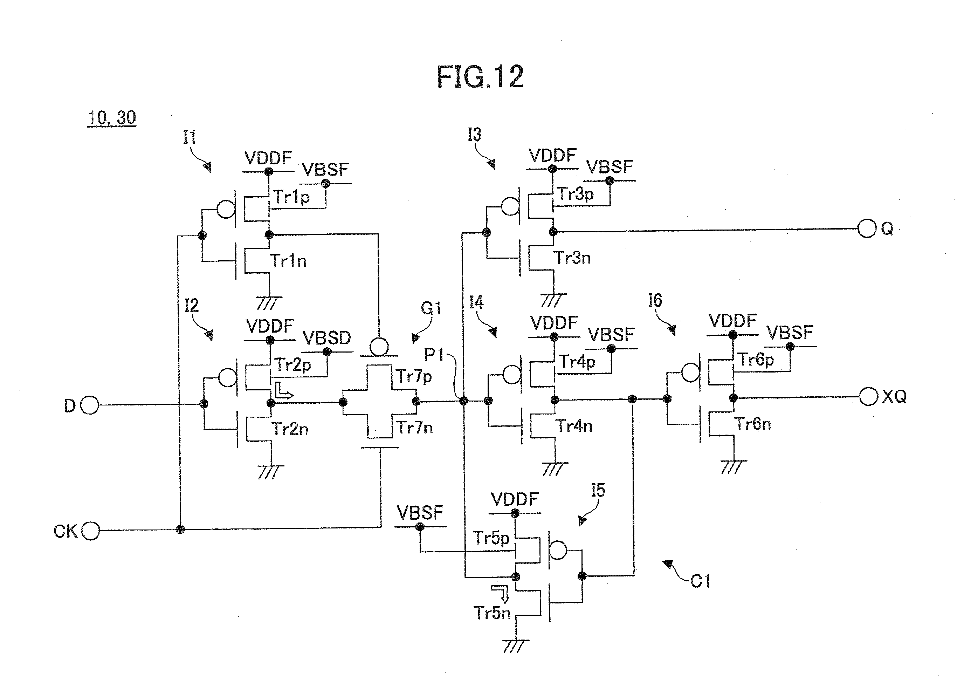

Next, a case of carrying out the WDFT test to the semiconductor device described with FIGs. 9, 10 and 11 will be described. First, it is assumed that as a result of the WDFT test being carried out with the substrate bias voltages VBS1 and VBS2 set to the same voltage, this has resulted in failure.
In this case, it is assumed that the test has been passed as a result of the WDFT test being carried out again with only the substrate bias voltage VBS2 having been set to provide a more forward bias. In such a case, the factor of the above-mentioned failure can be determined to be not a signal transfer delay trouble but a data taking-in characteristic problem of at least any one of the latch circuits 10 and 30. For this node, description will be made in more detail with FIGs. 12 and 8. It is noted that "with only the substrate bias voltage VBS2 having been set to provide a more forward bias" means a state in which, for the p-channel MOSFETs, the substrate bias voltage VBS1 is fixed, and the substrate bias voltage VBS2 is set lower than the substrata bias voltage VBS1.

FIG. 12 is similar to FIG. 11, and depicts an internal circuit configuration of the latch circuit 30. The data taking-in characteristics of the latch circuit 30 is determined by a relationship between the driving capability of the inverter circuit I2 and a function of the inverter circuit I5 (for a feedback) of one of the holding circuit C1 to maintain the immediately preceding state. It is noted that as depicted in FIG. 12 and so forth, to the p-channel MOSFET Tr2p of the inverter circuit I2, the substrate bias voltage VBSD is applied instead of the substrate bias voltage VBSF. FIG. 8 (a) depicts a waveform of the clock signal. FIG. 8 (b) and (c) depict voltage waveforms at an output node P1 of the transmission gate circuit G1 in a case where in FIG. 12, the value of the data signal that is input to the data input terminal D changes from the H level to the L level. In particular, FIG. 8 (b) depicts a waveform example for a case where the WDFT test is passed, and FIG. 8 (c) depicts a waveform example for a case where the WDFT test results in failure.

When the WDFT test is carried out on the circuit of FIG. 9, a data signal is input to the data input terminal D of the latch circuit 10, the logic circuit 20 carries out a logical operation, and the value of the logical operation result reaches the latch circuit 30. Further, in the latch circuit 30 depicted in FIG. 12, it is assumed that the immediately preceding state of the latch circuit 30 is a state in which the value of the data signal that is input to the data input terminal D has the H level. That is, the H level is inverted by the inverter circuit I2 into the L level, and the L level is output to the output node P1 via the transmission gate circuit G1. The inverter circuit I4 of the holding circuit C1 inverts the L level into the H level, and the inverter circuit I5 for a feedback of the holding circuit C1 gives the L level obtained from inverting the H level to the output node P1. Thus, in the immediately preceding state, the output node P1 outputs the L level value.

When the value of the data signal that is input to the data input terminal D is changed from the H level into the L level in the latch circuit 30 depicted in FIG. 12, the L level is inverted by the inverter circuit I2 into the H level. The H level is caused to pass through the transmission gate circuit G1 while the clock signal has the H level, and changes the output node P1 into the H level. At this time, as mentioned above, in the immediately preceding state, the inverter circuit I5 for a feedback of the holding circuit C1 outputs the L level from the output node P1, has a function of connecting the output node P1 to the ground side, as indicated by an arrow in FIG. 12, and maintaining the voltage of the output node P1 at the L level.

FIG. 8 (b) depicts a case where the driving capability of the inverter circuit I2 that drives the signal is greater than the function of maintaining the voltage of the output node P1 at the L level by the driving capability of the inverter circuit I5 for a feedback of the holding circuit C1. It is noted that as depicted in FIG. 12 and so forth, the substrate bias voltage VBSD is applied to the p-channel MOSFET Tr2p of the inverter circuit I2 instead of the substrate bias voltage VBSF. In this case, as depicted in FIG. 8 (b), the voltage of the output node P1 is sufficiently increased while the clock signal has the H level depicted in FIG. 8 (a). As a result, in the holding circuit C1, the output of the inverter I4 has the L level value. Then, by the L level value, the output of the inverter circuit I5 has the H level value. Thus, the holding circuit C1 is changed into the state corresponding to the value of the output of the inverter circuit I2, and the latch circuit 30 can take in the value of the data signal. As a result, the semiconductor device passes in the WDFT test.

On the other hand, FIG. 8 (c) depicts a case where the function of maintaining the voltage of the output node P1 at the L level value by the driving capability of the inverter circuit I5 for a feedback of the holding circuit C1 is greater than the driving capability of the inverter circuit I2. In this case, as depicted in FIG. 8 (c), the voltage of the output node P1 cannot be sufficiently increased while the clock signal has the H level depicted in FIG. 8 (a). As a result, in the holding circuit C1, the output of the inverter I4 is maintained at the H level value. Thus, the output of the inverter circuit I5 is maintained at the L level value. Thus, while the clock signal has the H level, the holding circuit C1 is maintained in the immediately preceding state. Thus, the holding circuit C1 cannot be changed into the state corresponding to the value of the output of the inverter circuit I2 while the clock signal has the H level. Then, when the clock signal comes to have the L level value, the transmission gate circuit G1 is closed, and the output of the inverter I2 is cut off. As a result, the voltage of the output node P1 has the L level value that is the output of the inverter circuit I5 for a feedback of the holding circuit C1, and thus, the latch circuit 30 cannot take in the value of the data signal. Thus, the data transfer operation is not completed within the predetermined signal transfer delay time, and the semiconductor device fails in the WDFT test.

In a case where the semiconductor device has thus failed in the WDFT test (the case of FIG. 8(c) , the WDFT test is again carried out with only the substrate bias voltage VBS2 that has been set again to a voltage to provide a more forward bias. Thus, the substrate bias voltage VBSD is set to provide a more forward bias in comparison to the substrate bias voltage VBSF. "The substrate bias voltage VBSD is set to provide a more forward bias in comparison to the substrate bias voltage VBSF" means that the substrate bias voltage VBSF is fixed, and the substrate bias voltage VBSD is set lower than VBSF. A substrate of a p-channel MOSFET is an n-channel semiconductor, and it is assumed that a substrate bias voltage is usually 1 V. In this case, by reducing the substrate bias voltage of 1 V and setting to, for example, 0.9 V, the threshold voltage of the p-channel MOSFET is reduced, and the driving capability is increased. Thus, the substrate bias voltage of the p-channel MOSFET Tr2p of the inverter circuit I2 of FIG. 12 comes to provide a more forward bias, and the driving capability of the inverter circuit I2 is increased. As a result, the state of FIG. 8 (b). That is, the driving capability of the inverter circuit I2 that drives the signal becomes greater than the function of maintaining the voltage of the output node P1 at the L level value by the inverter circuit I5 for a feedback of the holding circuit C1. As a result, the voltage at the output node P1 is sufficiently increased while the clock signal has the H level, the holding circuit C1 is changed into the state corresponding to the value of the output of the inverter circuit 12, and the latch circuit 30 can take in the value of the data signal. Thus, in a case where the semiconductor device does not have a signal transfer delay problem, and the WDFT test results in failure due to power-supply noise, the WDFT test is carried out again with only the substrate bias voltage VBS2 set to a voltage to provide a more forward bias. When the latch circuit 30 can take in the value of the data signal within the predetermined signal transfer delay time consequently, it is possible to determine that the semiconductor device does not have a signal transfer delay problem. On the other hand, in a case where the semiconductor device actually has a signal transfer delay problem, the latch circuit 30 still cannot take in the value of the data signal even when the WDFT test is carried out again with only the substrate bias voltage VBS2 set to a voltage to provide a more forward bias. Thus, in this case, it is possible to determine that the semiconductor device has a signal transfer delay problem. Thus, according to the embodiment 2, even when a variation in the power supply voltage due to power-supply noise exists, it is possible to positively determine whether the semiconductor device having failed in the WDFT test actually has a signal transfer delay problem. It is noted that "with only the substrate bias voltage VBS2 set to a voltage to provide a more forward bias" is a state in which the substrate bias voltage VBS1 is fixed, and the substrate bias voltage VBS2 is set lower than VBS1.

Further, in a case where it has been determined that the semiconductor device does not have a signal transfer delay problem, and the WDFT test results in failure due to power-supply noise, the LSI may be shipped with only the substrate bias voltage VBS2 set to a voltage to provide a more forward bias. "With only the substrate bias voltage VBS2 set to a voltage to provide a more forward bias" means that the substrate bias voltage VBS1 is fixed, and the substrate bias voltage VBS2 is set lower than VBS1. That is, the LSI may be shipped in the state in which the latch circuit 30 can take in a value of a data signal within the predetermined signal transfer delay time even with power-supply noise. Further, in a case where, conversely, it has been determined that the semiconductor device actually has a signal transfer delay problem, the LSI is shipped with only the substrate bias voltage VBS1 having been set lower. "With only the substrate bias voltage VBS1 having been set lower" means that the substrate bias voltage VBS2 is fixed, and the substrate bias voltage VBS1 is set lower than VBS2. That is, the shipping may be carried out with the substrate bias voltage of the p-channel MOSFETs of the latch circuits 10 and 30 other than the inverter circuits I2 to a voltage to provide a more foreword bias. That is, the shipping may be carried out with the substrate bias voltage of the p-channel MOSFETs of the latch circuits 10 and 30 other than the inverter circuits I2 lower than the substrate bias voltage of the p-channel MOSFETs Tr2p of the inverter circuits I2. By making the substrate bias voltage of the p-channel MOSFETs of the latch circuits 10 and 30 other than the inverter circuits I2 lower than the substrate bias voltage of the p-channel MOSFETs Tr2p of the inverter circuits I2, the driving capabilities of the p-channel MOSFETs of the latch circuits 10 and 30 other than the inverter circuits I2 are increased, and the operation speeds are increased. As a result, it is possible to solve the signal transfer delay problem.

Thus, according to the embodiment 2, the power system (VBSD) of the substrate bias voltage for the p-channel MOSFETs Tr2p of the transistors of the inverter circuits I2 of the latch circuits 10 and 30 respectively provided on the input and output sides of the logic circuit 20 included in the semiconductor device is separated from the power supply system (VBSF) of the substrate bias voltage of the other p-channel MOSFETs. Then, when the WDFT test is carried out, the power supply voltage (VBSD) of the substrate bias voltage of the p-channel MOSFETs of the inverter circuits I2 included in the latch circuits 10 and 30 is adjusted separately from the power supply voltage (VBSF) of the substrate bias voltage the other p-channel MOSFETs. As a result, in a case where the semiconductor device has a problem, it is possible to easily determine whether the problem occurs due to a signal transfer delay problem between the latch circuits 10 and 30 or a problem concerning the data taking-in characteristics of the latch circuits 10 and 30. Further, it is possible to solve the problem in an appropriate manner according to the determination result.

It is noted that for the embodiment 2, the substrate bias voltages of p-channel MOSFETs have been described as those for increasing the driving capabilities by changing the threshold voltages of the transistors. However, an embodiment of the present invention is not limited to this example. That is, the substrate bias voltages of n-channel MOSFETs may also be used as those for increasing the driving capabilities by changing the threshold voltages of the transistors. Further, the substrate bias voltages of both of p-channel MOSFETs and n-channel MOSFETs may also be used as those for increasing the driving capabilities by changing the threshold voltages of the transistors.

Next, a LSI according to an embodiment 3 and a test method for the LSI will be described. To the LSI of the embodiment 3, it is possible to apply the semiconductor device according to the embodiment 1 or the embodiment 2.

The LSI according to the embodiment 3 is mounted, for example, on a CPU (Central Processing Unit) of a server apparatus, and, in the LSI, the latch circuits 10 and 30 included in the semiconductor device according to the embodiment 1 or the embodiment 2 are applied to monitoring circuits described above for the LSI.

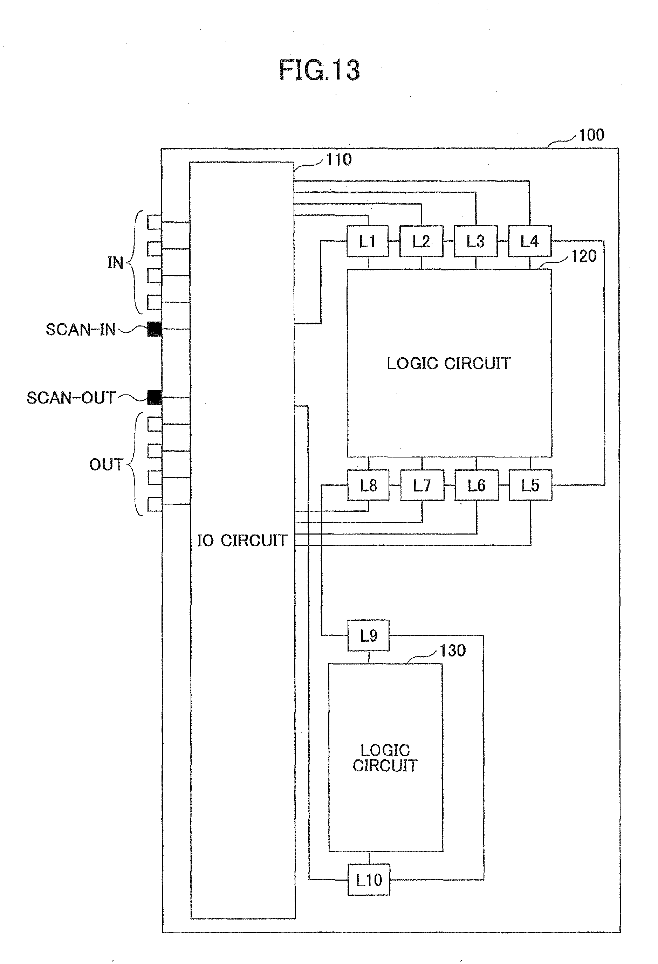

FIG. 13 depicts an overall circuit diagram of the LSI 100. As depicted in FIG. 13, the LSI 100 has a logic circuit 120, and an IO (Input Output) circuit 110 as an interface to the outside. The LSI 100 further has latch circuits or flip-flop circuits (hereinafter, simply referred to as latch circuits) L1 through L4 on the input side of the logic circuit 120 and latch circuits or flip-flop circuits (hereinafter, simply referred to as latch circuits) L5 through L8 on the output side of the logic circuit 120. The latch circuits L1 through L4 and L5 through L10 have, for example, the above-mentioned configurations of the latch circuits mentioned above with FIG. 2, respectively, and a common power supply voltage (for example, the above-mentioned VDDF) is supplied thereto. Further, input terminals IN and output terminals OUT, and a scan-in terminal SCAN-IN to which scan data is input and a scan-out terminal SCAN-OUT from which the scan data is output, both of which are respectively included in a LSI test interface based on the JTAG (Joint Test Architecture Group) standard of IEEE1149.1, are mounted to the LSI 100 as external terminals.

The LSI 100 further has a logic circuit 130, a latch circuit or a flip-flop circuit (hereinafter, simply referred to as a latch circuit) L9 on the input side and a latch circuit or a flip-flop circuit (hereinafter, simply referred to as a latch circuit) L10 on the input side of the logic circuit 130, for monitoring. The latch circuits L9 and L10 have, for example, the above-mentioned configurations of the latch circuits 10 and 30 of the embodiment 1 mentioned above with FIG. 5 or the above-mentioned configurations of the latch circuits 10 and 30 (embodiment 2) of the embodiment 2 mentioned above with FIG. 10, respectively. That is, the latch circuits L9 and L10 and the logic circuit 130 included in the LSI 100 depicted in FIG. 13 correspond to, for example, the latch circuits 10 and 30 and the logic circuit 20 of the embodiment 1 depicted in FIG. 4, respectively. Similarly, the latch circuits L9 and L10 and the logic circuit 130 included in the LSI 100 depicted in FIG. 13 correspond to, for example, the latch circuits 10 and 30 and the logic circuit 20 of the embodiment 2 depicted in FIG. 9, respectively.

Next, operations of the LSI 100 will be described. At a time of usual operations, data signals and a clock signal are input from the input terminals IN via the IO circuit 110. The data signals are input to the logic circuit 120 via the latch circuits L1 through L4 on the input side by the clock signal, and values of logic operation results of the logic circuit 120 are taken in by the latch circuits L5 through L8 on the output side.
The values taken in by the latch circuits L5 through L8 on the output side are taken out to the outside from the output terminals OUT via the IO circuit 110.

The scan-in terminal SCAN-IN and the scan-out terminal SCAN-OUT are used in a LSI test using scan shift. A LSI tester uses the latch circuits L1 through L4 on the input side as shift registers, inputs test data from the scan-in terminal SCAN-IN and sets it to the latch circuits L1 through L4 on the input side by applying a scan clock (not depicted) to the latch circuits L5 through L8. Next, by causing the logic circuit 120 to operate according to the test data that is thus set, the output values of the operation results are taken in by the latch circuits L5 through L8. Next, the latch circuits L5 through L8 on the output side are used as scan shift registers, the above-mentioned output values of the operation results are taken out from the scan-out terminal SCAN-OUT, by applying a scan clock (not depicted) to the latch circuits L5 through L8. The LSI tester (described later) compares the output values of the operation results with expected values, and confirms whether to agree with the expected values.

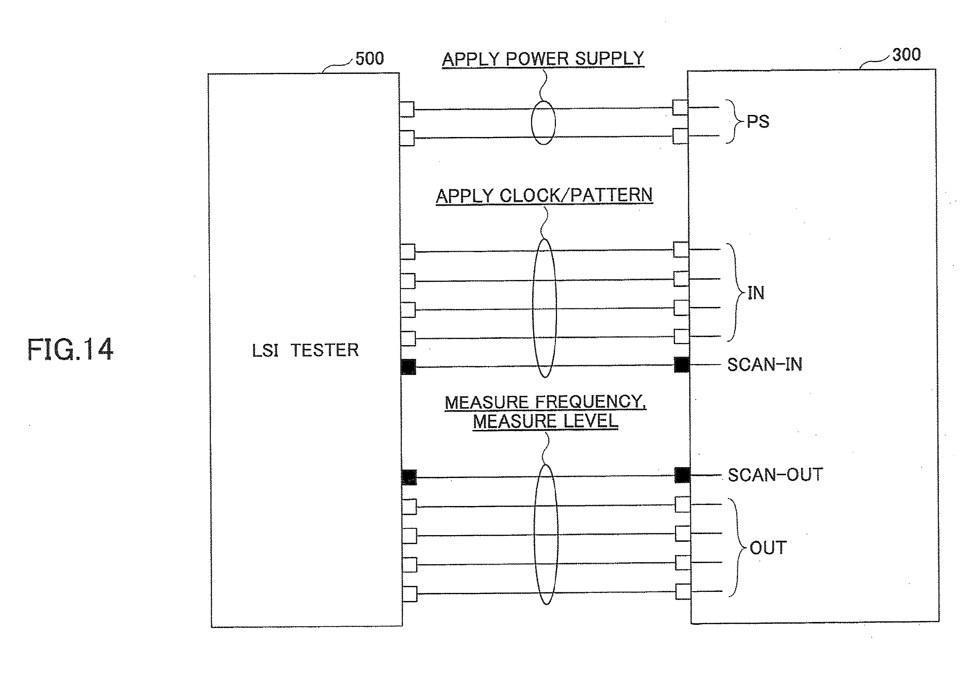

FIG. 14 depicts a state of connections when an LSI 300 is tested. The LSI 300 is the LSI 100 described above with FIG. 13. When the LSI 300 is tested, the LSI tester 500 is used. A power supply voltage is applied from power supply terminals PS, from the LSI tester 500 to the LSI 300. Test pattern signals and a clock signal are input from the input terminals IN and the scan-in terminal SCAN-IN. Then, the output values are taken out from the output terminals OUT and the scan-out terminal SCAN-OUT, and are compared with expected values, and it is confirmed whether to agree with the expected values. At this time, as is necessary, voltage levels and frequencies of the output signals obtained from the output terminals OUT are measured.

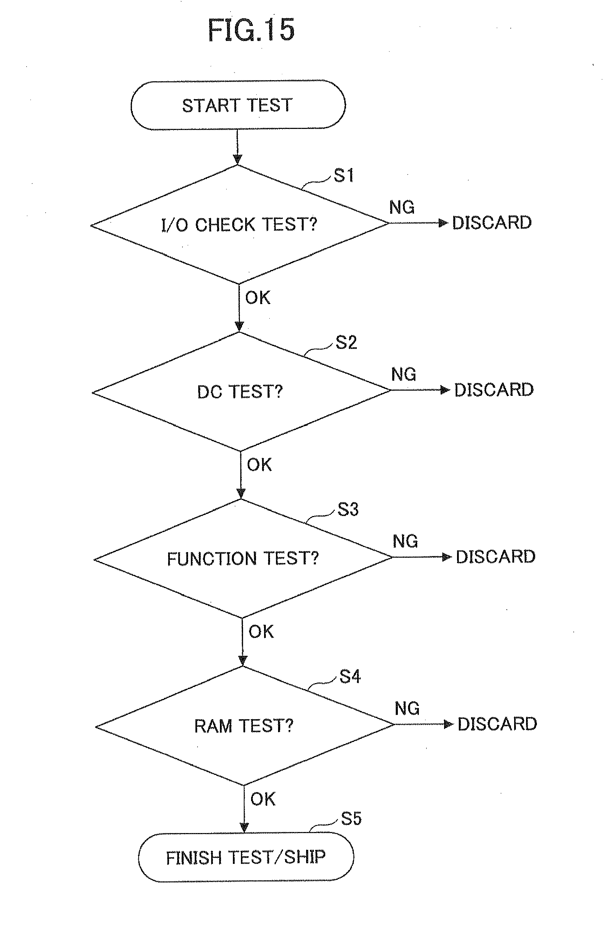

FIG. 15 depicts a flowchart of the above-mentioned test of the LSI 300. In FIG. 15, first in step S1, an I/O check test is carried out. Here, it is confirmed whether the input terminals IN, the output terminals OUT, the scan-in terminal SCAN-IN, the scan-out terminal SCAN-OUT and so forth are not mutually short-circuited. Next, in step S2, a DC test is carried out. In the DC test, resting currents flowing through the LSI 100, the oscillation frequency of a ROSC (Ring OSCillator), and/or the like, are measured. Next, in step S3, a function test is carried out. In the function test, a clock signal is applied to the LSI 300, and operations of the LSI 300 are confirmed. Next, in step S4, a RAM (Random Access Memory) test is carried out. In the RAM test, operations of RAMs (not depicted) included in the LSI 300 are tested.
A LSI 300 that has passed in the respective tests of steps S1 through S4 is shipped in step S5. On the other hand, a LSI 300 that has failed in any one of the respective tests of steps S1 through S4 is discarded.

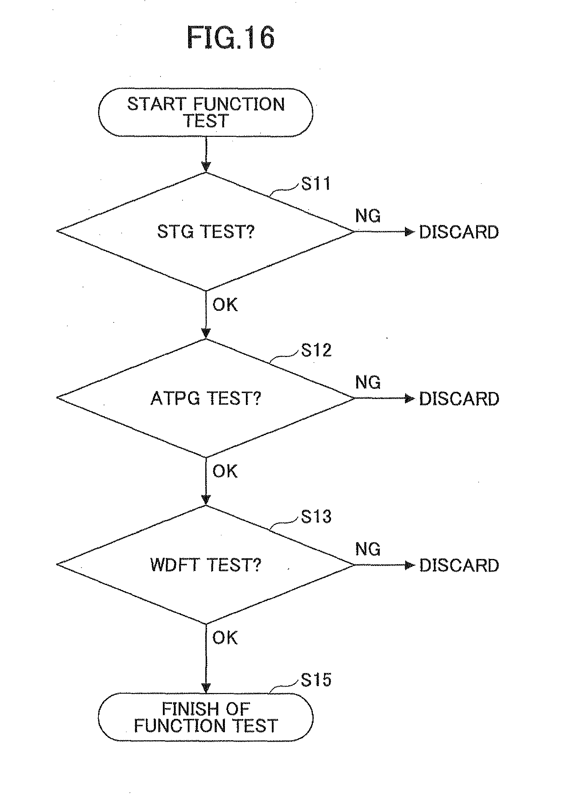

FIG. 16 depicts a detailed flowchart of the function test of step S3 of the flowchart of FIG. 15. In FIG. 16, in step S11, a STG (Scan Test Generation) test is carried out. In the STG test, a test using scan shift mentioned above with FIG. 13 is carried out. Next, in step S12, an ATPG test is carried out. In the ATPG test, test signals are input to the logic circuit 120 via the latch circuits L1 through L4 on the input side depicted in FIG. 13, and it is confirmed that the latch circuits L5 through L8 on the output side can take in the values of the operation results of the logic circuit 120. Next, in step S13, a WDFT test is carried out. In the WDFT test, test signals are input to the logic circuit 120 via the latch circuits L1 through L4 on the input side depicted in FIG. 13, and it is confirmed that the latch circuits L5 through L8 on the output side can take in the values of the operation results of the logic circuit 120 within the predetermined signal transfer delay time. In a case where the LSI 300 has passed in the respective tests of steps S11, S12 and S13, the LSI 300 is shipped (step S15). On the other hand, any one of the tests has resulted in failure, the LSI 300 is discarded.

In the test of the LSI 300 according to the embodiment 3, the power supply voltages VDDF and VDDD applied to the latch circuits L9 and L10 for monitoring of FIG. 13 (for example, the latch circuits 10 and 30 (embodiment 1) of FIG. 5) are made the same as one another. Further, the power supply voltage applied to the other latch circuits L1 through L8 are made to be VDDF. Then, the power supply voltage VDDF is made to be 0.8 through 1.2 V (by 0.1 V), and the AGPG test is carried out. Then, it is determined as passing in a case where the latch circuits L5 through L8 on the output side could take in the desired values with the power supply voltage of 1.0 V ±10%. Table 1 depicts an example of the test result at this time.

**[Table 1]**

| Voltage | 0.8 V | 0.9 V | 1.0 V | 1.1 V | 1.2 V |
|---|---|---|---|---|---|
| ATPG test | × | ○ | ○ | ○ | ○ |
| WDFT test | × | × | ○ | ○ | ○ |

Table 1 depicts that in the LSI 300, the latch circuits L5 through L8 on the output side could take in the desired values with the power supply voltages VDDF and VDDD greater than or equal to 0.9 V. Thus, the passing requirement of 1.0 V ± 10% is satisfied, and thus, the ATPG test is passed.

On the other hand, Table 1 depicts that in the WDFT test, the latch circuits L5 through L8 on the output side could not take in the desired values with the power supply voltages VDDF and VDDD less than or equal to 0.9 V. Thus, assuming that the passing requirement of the WDFT test is also the passing requirement 1.0 V±10%, this passing requirement is not satisfied, and thus, the LSI 300 fails in the WDFT test.

Here, as the factor by which the LSI 300 has thus failed in the WDFT test, a factor other than a signal transfer delay problem may be considered. That is, there is a possibility that the LSI 300 has failed in the WDFT test because, as mentioned above, the power supply voltages falls in consequence of power-supply noise generated by the use of a high-rate clock signal. This point will now be confirmed. That is, the WDFT test is again carried out with the power supply voltages VDDD of 1.0 V and VDDF of 0.9 V applied to the latch circuits L9 and L10 for monitoring of FIG. 13 (for example, the latch circuits 10 and 30 (embodiment 1) of FIG. 5). Then, in a case where the latch circuit L10 on the output side consequently has taken in the desired value within the predetermined signal transfer delay time, it can be confirmed that at least the latch circuits L9 and L10 and the logic circuit 130 for monitoring do not have a signal transfer delay problem. That is, it can be determined that the LSI 300 has failed in the WDFT test in the result of Table 1 because the power supply voltages have fallen in consequence of power-supply noise generated by the use of the high-rate clock signal. It is noted that also the latch circuits L1 through L8 and the logic circuit 130 included in the LSI 300 are included in the LSI 300 of the same chip as that of the latch circuits L9 and L10 and the logic circuit 130 for monitoring. Thus, the same as the above-mentioned, it can be determined that the LSI 300 has failed in the WDFT test in the result of Table 1 because the power supply voltages have fallen in consequence of power-supply noise generated by the use of the high-rate clock signal.

Further, in a case of applying the above-mentioned embodiment 2, the substrate bias voltage VBSD applied to the latch circuits L9 and L10 for monitoring of FIG. 13 (for example, the latch circuits 10 and 30 of FIG. 10) is set to a voltage to provide a more forward bias, and the WDFT test is again carried out. To set the substrate bias voltage VBSD to a voltage to provide a more forward bias means that the substrate bias voltage VBSF is fixed, and the substrate bias voltage VBSD is set lower than VBSF. Then, in a case where the latch circuit L10 on the output side consequently has taken in the desired value within the predetermined signal transfer delay time, it can be determined that at least the latch circuits L9 and L10 and the logic circuit 130 for monitoring do not have a signal transfer delay problem. That is, it can be determined that the LSI 300 has failed in the WDFT test in the result of Table 1 because the power supply voltages have fallen in consequence of power-supply noise generated by the use of the high-rate clock signal. The same as the above-mentioned, also the latch circuits L1 through L8 and the logic circuit 130 included in the LSI 300 are included in the LSI 300 of the same chip as that of the latch circuits L9 and L10 and the logic circuit 130 for monitoring. Thus, the same as the above-mentioned, it can be determined that the LSI 300 has failed in the WDFT test in the result of Table 1 because the power supply voltages have fallen in consequence of power-supply noise generated by the use of the high-rate clock signal.

Thus, in the LSI 100 according to the embodiment 3, it is possible to correctly determine the factor of a problem of an LSI having the problem. Thus, it is possible to cope with the problem, based on the determination result, by improving the data taking-in characteristics of the latch circuits at a time of designing a product of a next technology, increasing a capacitor's capacitance to be used for suppressing power-supply noise, or the like.

Next, a LSI according to an embodiment 4 and a test method for the LSI will be described. Also to the LSI of the embodiment 4, it is possible to apply the semiconductor device according to the embodiment 1 or the embodiment 2 mentioned above.

Also the LSI according to the embodiment 4 is mounted, for example, on a CPU of a server apparatus, and, in the LSI, the latch circuits 10 and 30 included in the semiconductor device according to the embodiment 1 or the embodiment 2 are applied to latch circuits described later.

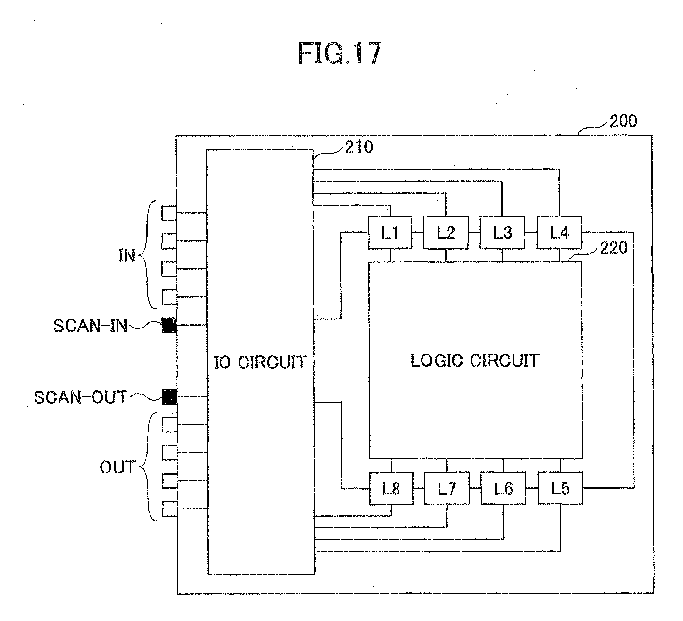

FIG. 17 depicts an overall circuit diagram of the LSI 200. As depicted in FIG. 17, the LSI 200 has a logic circuit 220, and an IO circuit 210 as an interface to the outside. The LSI 200 further has latch circuits or flip-flop circuits (hereinafter, simply referred to as latch circuits) L1 through L4 on the input side of the logic circuit 220 and latch circuits or flip-flop circuits (hereinafter, simply referred to as latch circuits) L5 through L8 on the output side of the logic circuit 220. The latch circuits L1 through L4 and L5 through L10 have, for example, the above-mentioned configurations of the latch circuits 10 and 30 mentioned above with FIG. 5 or the above-mentioned configurations of the latch circuits 10 and 30 mentioned above with FIG. 10, respectively. That is, each of the latch circuits L1 through L4, included in the LSI 200, corresponds to the latch circuit 10 depicted in FIG. 4; each of the latch circuits L5 through L8 corresponds to the latch circuit 30 depicted in FIG. 4; and the logic circuit 220 corresponds to the logic circuit 20. Similarly, each of the latch circuits L1 through L4, included in the LSI 200, corresponds to the latch circuit 10 depicted in FIG. 9; each of the latch circuits L5 through L8 corresponds to the latch circuit 30 depicted in FIG. 9; and the logic circuit 220 corresponds to the logic circuit 20. Further, input terminals IN and output terminals OUT, and a scan-in terminal SCAN-IN to which scan data is input and a scan-out terminal SCAN-OUT from which the scan data is output, both of which are respectively included in a LSI test interface based on JTAG (Joint Test Architecture Group) standard of IEEE1149.1, are mounted to the LSI 200, as external terminals.

Next, operations of the LSI 200 will be described. At a time of usual operations, data signals and a clock signal are input from the input terminals IN via the IO circuit 210. The data signals are input to the logic circuit 220 via the latch circuits L1 through L4 on the input side by the clock signal, and values of logic operation results of the logic circuit 220 are taken in by the latch circuits L5 through L8 on the output side.
The values taken in by the latch circuits L5 through L8 on the output side are taken out to the outside from the output terminals OUT via the IO circuit 210.

The scan-in terminal SCAN-IN and the scan-out terminal SCAN-OUT are used in a LSI test using scan shift. According to scan shift, the latch circuits L1 through L4 on the input side are used as shift registers, test data is input from the scan-in terminal SCAN-IN and is set to the latch circuits L1 through L4 on the input side by applying a scan clock (not depicted) to the latch circuits L1 through L4. Next, by causing the logic circuit 220 to operate according to the test data that is thus set, the output values of the operation results are taken in by the latch circuits L5 through L8. Next, the latch circuits L5 through L8 on the output side are used as shift registers, the above-mentioned output values of the operation results are taken out from the scan-out terminal SCAN-OUT, by applying a scan clock (not depicted) to the latch circuits L5 through L8. The thus taken out output values of the operation results are compared with expected values, and it is confirmed whether to agree with the expected values.

FIG. 14 depicts a state of connections when an LSI 300 is tested. The LSI 300 is the LSI 200 described above with FIG. 17. When the LSI 300 is tested, the LSI tester 500 is used. A power supply voltage is applied from power supply terminals PS, from the LSI tester 500 to the LSI 300. Test pattern signals and a clock signal are input from the input terminals IN and the scan-in terminal SCAN-IN. Then, the output values are taken out from the output terminals OUT and the scan-out terminal SCAN-OUT, and are compared with expected values, and it is confirmed whether to agree with the expected values. At this time, as is necessary, voltage levels and frequencies of the output signals obtained from the output terminals OUT are measured.

FIG. 15 depicts a flowchart of a test of the LSI 300. Description of the flowchart is the same as that having been made for the above-mentioned embodiment 3, and thus, duplicate description will be omitted.

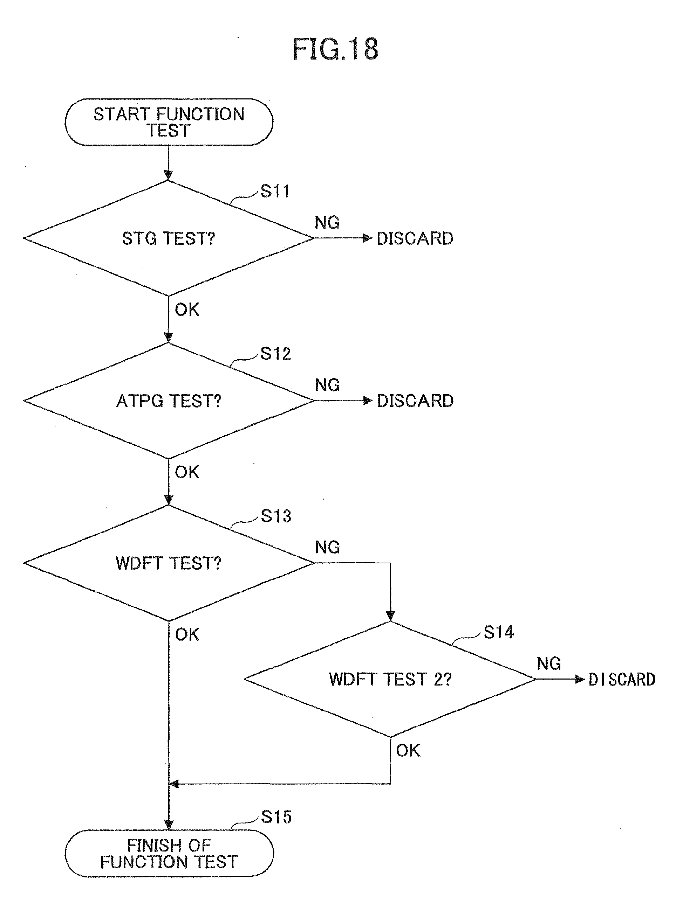

FIG. 18 depicts a detailed flowchart of the function test of step S3 of the flowchart of FIG. 15. In FIG. 18, in step S11, a STG (Scan Test Generation) test is carried out. In the STG test, a test using scan shift mentioned above with FIG. 17 is carried out. Next, in step S12, an ATPG test is carried out. In the ATPG test, test signals are input to the logic circuit 120 via the latch circuits L1 through L4 on the input side depicted in FIG. 17, and it is confirmed that the latch circuits L5 through L8 on the output side can take in the values of the operation results of the logic circuit 220. Next, in step S13, a WDFT test is carried out.
In the WDFT test, test signals are input to the logic circuit 120 via the latch circuits L1 through L4 on the input side depicted in FIG. 17, and it is confirmed that the latch circuits L5 through L8 on the output side can take in the values of the operation results of the logic circuit 220 within the predetermined signal transfer delay time.

In the LSI test according to the embodiment 4, the power supply voltages VDDF and VDDD applied to the latch circuits L1 through L8 of FIG. 17 (for example, the latch circuits 10 and 30 (embodiment 1) of FIG. 5) are made to be the same as one another. Then, the power supply voltage VDDF is made to be 0.8 through 1.2 V (by 0.1 V), and the AGPG test is carried out. Then, it is determined as passing in a case where the latch circuits L5 through L8 on the output side could take in the desired values with the power supply voltage of 1.0 V ±10%. Table 2 depicts an example of the test result at this time.

**[Table 2]**

| Voltage | 0.8 V | 0.9 V | 1.0 V | 1.1 V | 1.2 V |
|---|---|---|---|---|---|
| ATPG test | × | ○ | ○ | ○ | ○ |
| WDFT test | × | × | ○ | ○ | ○ |

Table 2 depicts that the latch circuits L5 through L8 on the output side could take in the desired values with the power supply voltages VDDF and VDDD greater than or equal to 0.9 V. Thus, the passing requirement of 1.0 V±10% is satisfied, and thus, the LSI 300 passes in the ATPG test.

On the other hand, Table 2 depicts that in the WDFT test, the latch circuits L5 through L8 on the output side could not take in the desired values with the power supply voltages VDDF and VDDD less than or equal to 0.9 V. Thus, assuming that the passing requirement of the WDFT test is also the passing requirement 1.0 V±10%, this passing requirement is not satisfied, and thus, the LSI 300 fails in the WDFT test. Thus, the LSI 300 cannot be shipped as it is.

Here, the same as the above-mentioned, as the factor by which the LSI 300 has thus failed in the WDFT test, a factor other than a signal transfer delay problem may be considered. That is, there is a possibility that the LSI 300 has failed in the WDFT test because, as mentioned above, the power supply voltages has fallen in consequence of power-supply noise generated by the use of a high-rate clock signal. This point will now be confirmed. That is, the WDFT test is again carried out with the power supply voltages VDDD of 1.0 V and VDDF of 0.9 V applied to the latch circuits L1 through L8 of FIG. 17 (for example, the latch circuits 10 and 30 (embodiment 1) of FIG. 5) (step S14 of FIG. 18). Then, in a case where the latch circuits L5 through L8 on the output side consequently have taken in the desired values within the predetermined signal transfer delay time, it can be confirmed that the latch circuits L5 through L8 and the logic circuit 220 do not have a signal transfer delay problem. That is, it can be determined that the LSI 300 has failed in the WDFT test in the result of Table 2 because the power supply voltages have fallen in consequence of power-supply noise generated by the use of the high-rate clock signal. In this case, the LSI 300 can be shipped by setting the power supply voltages VDDD to 1.0 V and VDDF to 0.9 V (in step S14 OK, step S15).

Further, in a case of applying the above-mentioned embodiment 2, the substrate bias voltage VBSD applied to the p-channel MOSFETs of the latch circuits L1 through L8 of FIG. 17 (for example, the latch circuits 10 and 30 of FIG. 10) is set to a voltage to provide a more forward bias, and the WDFT test is again carried out (step S14 of FIG. 18). To set the substrate bias voltage VBSD to a voltage to provide a more forward bias means that the substrate bias voltage VBSF is fixed, and the substrate bias voltage VBSD is set lower than VBSF. Then, in a case where the latch circuits L5 through L8 on the output side consequently have taken in the desired values within the predetermined signal transfer delay time, it can be confirmed that the latch circuits L1 through L8 and the logic circuit 220 do not have a signal transfer delay problem. That is, it can be determined that the LSI 300 has failed in the WDFT test in the result of Table 2 because the power supply voltages have fallen in consequence of power-supply noise generated by the use of the high-rate clock signal. In this case, the LSI 300 can be shipped by setting the substrate bias voltage VBSD applied to the respective latch circuits L1 through L8 (for example, the latch circuits 10 and 30 of FIG. 10) to a "voltage to provide a more forward bias" (step S14 OK, step S15). To set the substrate bias voltage VBSD to a voltage to provide a more forward bias means that the substrate bias voltage VBSF is fixed, and the substrate bias voltage VBSD is set lower than VBSF.

Thus, in the LSI 200 according to the embodiment 4, it is possible to correctly determine the factor of a problem of an LSI having the problem. Thus, it is possible to cope with the problem, based on the determination result, by improving the data taking-in characteristics of the latch circuits at a time of designing a product of a next technology, increasing a capacitor's capacitance to be used for suppressing power-supply noise, or the like.

Furthermore, even in a case where the LSI 300 fails in the first WDFT test (step S13 of FIG. 18), the LSI 300 can be shipped in a case where the next WDFT test (step S14) is passed. Thus, the yield of LSI products is improved.

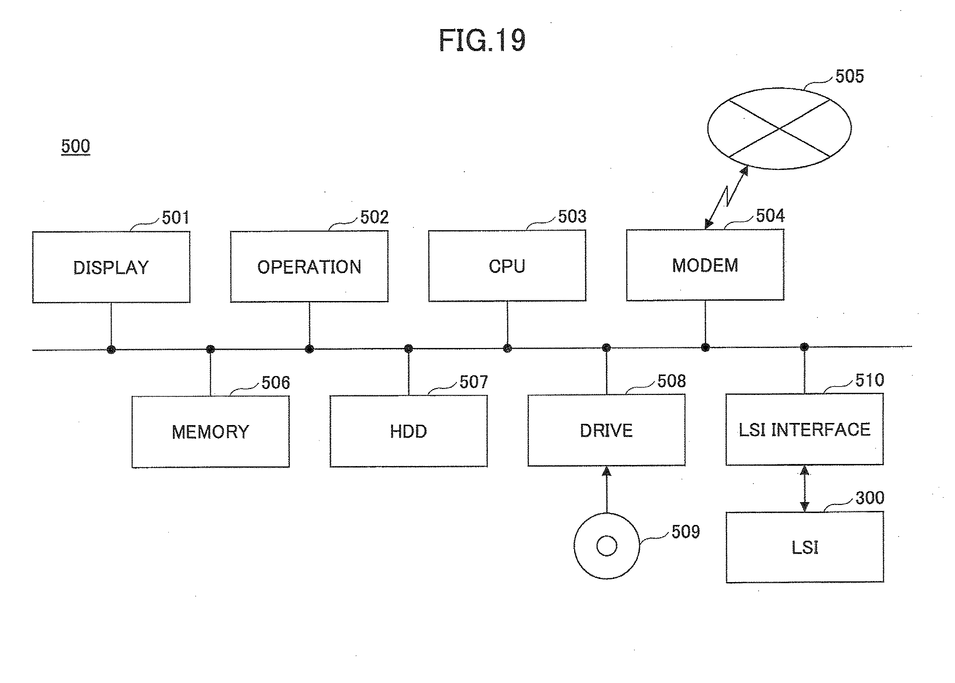

FIG. 19 is a block diagram depicting a configuration example of a computer in a case where the LSI tester 500 depicted in FIG. 14 is realized by the computer as an information processing apparatus.

As depicted in FIG. 19, the computer 500 has a CPU 503 as a processor that carries out various operations by executing instructions that are included in a given program. The computer 500 further has an operation part 502 including a keyboard, a mouse and/or the like, and used by a user to input operation contents or data; and a display part 501 including a CRT, a liquid crystal display or the like for displaying a processing progress, a processing result and/or the like of the CPU 503 to the user. The computer 500 further has a memory 506 including a ROM (Read Only Memory), a RAM and/or the like, storing programs to be executed by the CPU 503, data and/or the like, or used as a work area. The computer 500 further has a hard disk drive 507 that stores the programs, data and/or the like. The computer 500 further has a CD-ROM drive 508 for loading the programs or loading the data from the outside using a CD-ROM (Compact Disk Read Only Memory) 509 as a medium. The computer 500 further has a modem 504 that is used when downloading the programs from an external server via a communication network 505 such as the Internet, a LAN (Local Area Network) of the like, or so. The computer 500 further has a LSI interface 510 as an interface to the LSI 300.

The above-mentioned computer 500 loads, through the CD-ROM 509, a program for causing the CPU 503 to carry out processes of automatically carrying out a test(s) of the LSI 300 described above with FIGs. 14, 15, 16, 18 and/or the like. Or, the computer 500 downloads, through the communication network 504, a program for causing the CPU 503 to carry out processes of automatically carrying out a test(s) of the LSI 300 described above with FIGs. 14, 15, 16, 18 and/or the like. Then, the program is installed in the hard disk drive 507, is appropriately loaded in the memory 506, and is executed by the CPU 503. As a result, the LSI tester 500 is realized by the computer 500.

It is noted that it is also possible to combine the above-mentioned embodiment 1 and embodiment 2 and apply them. That is, there may be an embodiment in which, in latch circuits included in a LSI, power supply to transistors is separated (VDDF and VDDD) as depicted in FIG. 5, and also, substrate bias power supply to p-channel MOSFETs is separated (VBSF and VBSD) as depicted in FIG. 10.
In this case, in a case where the LSI has failed in the WDFT test, the power supply voltage of the transistors of the inverter circuits I2 of the latch circuits on the input side and the output side of the logic circuits is increased. Further simultaneously, the substrate bias voltage of the inverter circuits I2 is changed to a voltage to provide a more forward bias (in a case of p-channel MOSFETs, the substrate bias voltage is reduced). As a result, in a case where, in the LSI, the latch circuits on the output side consequently can take in desired values within the predetermined signal transfer delay time in the WDFT test, it is possible to determine that the factor of the first failure is not a signal transfer delay problem but a reduction in the power supply voltage(s) due to power-supply noise. Further, it is possible to ship the LSI by increasing the power supply voltage, and also, changing the substrate bias voltage to a voltage to provide a more forward bias (in a case of p-channel MOSFETs, reducing the substrate bias voltage) of the transistors of the inverter circuits I2 of the latch circuits on the input side and the output side of the logic circuits.

### DESCRIPTION OF REFERENCE NUMERALS

10, 30 latch circuits
20 logic circuit
C1 holding circuit
I1, I2, I3, I4, I5, I6 inverter circuits
G1 transmission gate circuit
Tr1p, Tr2p, Tt3p, Tr4p, Tr5p, Tr6p, Tr7p p-channel MOSFETs
Tr1n, Tr2n, Tt3n, Tr4n, Tr5n, Tr6n, Tr7n n-channel MOSFETs

## Claims

1. A semiconductor device **characterized by** having:
a first driving circuit to which first data is input;
a first gate circuit that causes the first data that the first driving circuit outputs to pass therethrough in a case where a clock signal is applied;
a first holding circuit that holds the first data that has passed through the first gate circuit;
a logic circuit that carries out a logic operation on the first data that the first holding circuit outputs, and outputs as second data;
a second driving circuit to which the second data that the logic circuit outputs is input;
a second gate circuit that causes the second data that the second driving circuit outputs to pass therethrough in a case where a clock signal is applied;
a second holding circuit that holds the second data that has passed through the second gate circuit; and
a power supply circuit that supplies a first voltage as a power supply voltage to the first and second gate circuits, the first and second holding circuits and the logic circuit, and supplies a second voltage higher than the first voltage as a power supply voltage to the first and second driving circuits.

2. The semiconductor device according to claim 1, **characterized in that**
the first and second driving circuits are inverter circuits;
the first and second gate circuits are transmission gate circuits; and
the first and second holding circuits include respective one pairs of inverter circuits that are connected to form loops.

3. The semiconductor device according to claim 2, **characterized by** having:
a first latch circuit that includes the first driving circuit, the first gate circuit and the first holding circuit; and
a second latch circuit that includes the second driving circuit, the second gate circuit and the second holding circuit.

4. A semiconductor device **characterized by** having:
a first driving circuit to which first data is input;
a first gate circuit that causes the first data that the first driving circuit outputs to pass therethrough in a case where a clock signal is applied;
a first holding circuit that holds the first data that has passed through the first gate circuit;
a logic circuit that outputs second data that is a result of carrying out a logic operation on the first data that the first holding circuit outputs;
a second driving circuit to which the second data that the logic circuit outputs is input;
a second gate circuit that causes the second data that the second driving circuit outputs to pass therethrough in a case where a clock signal is applied;
a second holding circuit that holds the second data that has passed through the second gate circuit; and
a power supply circuit that supplies a first substrate bias voltage as a substrate bias voltage of transistors included in the first and second gate circuits, the first and second holding circuits and the logic circuit, and supplies a second substrate bias voltage lower than the first substrate bias voltage to transistors included in the first and second driving circuits.

5. The semiconductor device according to claim 4, **characterized in that**
the first and second driving circuits are inverter circuits;
the first and second gate circuits are transmission gate circuits; and
the first and second holding circuits include respective one pairs of inverter circuits that are connected to form loops.

6. The semiconductor device according to claim 5, **characterized by** having:
a first latch circuit that includes the first driving circuit, the first gate circuit and the first holding circuit; and
a second latch circuit that includes the second driving circuit, the second gate circuit and the second holding circuit.

7. A test method for a semiconductor device that has a first driving circuit to which first data is input; a first gate circuit that causes the first data that the first driving circuit outputs to pass therethrough in a case where a clock signal is applied; a first holding circuit that holds the first data that has passed through the first gate circuit; a logic circuit that outputs second data that is a result of carrying out a logic operation on the first data that the first holding circuit outputs; a second driving circuit to which the second data that the logic circuit outputs is input; a second gate circuit that causes the second data that the second driving circuit outputs to pass therethrough in a case where a clock signal is applied; and a second holding circuit that holds the second data that has passed through the second gate circuit, **characterized by** having:
the step of supplying by a power supply circuit that the semiconductor device has a first voltage as a power supply voltage to the first and second driving circuits, the first and second gate circuits, the first and second holding circuits and the logic circuit, and confirming that the second holding circuit outputs the second data within a predetermined signal transfer time from when inputting the first data to the first driving circuit; and
the step of supplying by the power supply circuit that the semiconductor device has a second voltage higher than the first voltage as a power supply voltage to the first and second driving circuits in a case where the second holding circuit does not output the second data within the predetermined signal transfer time.

8. The test method for the semiconductor device according to claim 7, **characterized in that**
the first and second driving circuits are inverter circuits;
the first and second gate circuits are transmission gate circuits; and
the first and second holding circuits include respective one pairs of inverter circuits that are connected to form loops.

9. The test method for the semiconductor device according to claim 8, **characterized in that** the semiconductor device has:
a first latch circuit that includes the first driving circuit, the first gate circuit and the first holding circuit; and
a second latch circuit that includes the second driving circuit, the second gate circuit and the second holding circuit.

10. A test method for a semiconductor device that has a first driving circuit to which first data is input; a first gate circuit that causes the first data that the first driving circuit outputs to pass therethrough in a case where a clock signal is applied; a first holding circuit that holds the first data that has passed through the first gate circuit; a logic circuit that outputs second data that is a result of carrying out a logic operation on the first data that the first holding circuit outputs; a second driving circuit to which the second data that the logic circuit outputs is input; a second gate circuit that causes the second data that the second driving circuit outputs to pass therethrough in a case where a clock signal is applied; and a second holding circuit that holds the second data that has passed through the second gate circuit, **characterized by** having:
the step of supplying by a power supply circuit that the semiconductor device has a first substrate bias voltage as a substrate bias voltage of transistors included in the first and second driving circuits, the first and second gate circuits, the first and second holding circuits and the logic circuit, and confirming that the second holding circuit outputs the second data within a predetermined signal transfer time from when inputting the first data to the first driving circuit; and
the step of supplying by the power supply circuit that the semiconductor device has a second substrate bias voltage lower than the first substrate bias voltage to transistors included in the first and second driving circuits in a case where the second holding circuit does not output the second data within the predetermined signal transfer time.

11. The test method for the semiconductor device according to claim 10, **characterized in that**
the first and second driving circuits are inverter circuits;
the first and second gate circuits are transmission gate circuits; and
the first and second holding circuits include respective one pairs of inverter circuits that are connected to form loops.

12. The test method for the semiconductor device according to claim 11, **characterized in that** the semiconductor device has:
a first latch circuit that includes the first driving circuit, the first gate circuit and the first holding circuits; and
a second latch circuit that includes the second driving circuit, the second gate circuit and the second holding circuits.

13. A test program for a semiconductor device that has a first driving circuit to which first data is input; a first gate circuit that causes the first data that the first driving circuit outputs to pass therethrough in a case where a clock signal is applied; a first holding circuit that holds the first data that has passed through the first gate circuit; a logic circuit that outputs second data that is a result of carrying out a logic operation on the first data that the first holding circuit outputs; a second driving circuit to which the second data that the logic circuit outputs is input; a second gate circuit that causes the second data that the second driving circuit outputs to pass therethrough in a case where a clock signal is applied; and a second holding circuit that holds the second data that has passed through the second gate circuit, **characterized by** causing a computer to carry out:
the step of supplying by a power supply circuit that the semiconductor device has a first voltage as a power supply voltage to the first and second driving circuits, the first and second gate circuits, the first and second holding circuits and the logic circuit, and confirming that the second holding circuit outputs the second data within a predetermined signal transfer time from when inputting the first data to the first driving circuit; and
the step of supplying by the power supply circuit that the semiconductor device has a second voltage higher than the first voltage as a power supply voltage to the first and second driving circuits in a case where the second holding circuit does not output the second data within the predetermined signal transfer time.

14. The test program for the semiconductor device according to claim 13, **characterized in that**
the first and second driving circuits are inverter circuits;
the first and second gate circuits are transmission gate circuits; and
the first and second holding circuits include respective one pairs of inverter circuits that are connected to form loops.

15. The test program for the semiconductor device according to claim 14, **characterized in that** the semiconductor device has:
a first latch circuit that includes the first driving circuit, the first gate circuit and the first holding circuit; and
a second latch circuit that includes the second driving circuit, the second gate circuit and the second holding circuit.

16. A test program for a semiconductor device that has a first driving circuit to which first data is input; a first gate circuit that causes the first data that the first driving circuit outputs to pass therethrough in a case where a clock signal is applied; a first holding circuit that holds the first data that has passed through the first gate circuit; a logic circuit that outputs second data that is a result of carrying out a logic operation on the first data that the first holding circuit outputs; a second driving circuit to which the second data that the logic circuit outputs is input; a second gate circuit that causes the second data that the second driving circuit outputs to pass therethrough in a case where a clock signal is applied; and a second holding circuit that holds the second data that has passed through the second gate circuit, **characterized by** causing a computer to carry out:
the step of supplying by a power supply circuit that the semiconductor device has a first substrate bias voltage as a substrate bias voltage of transistors included in the first and second driving circuits, the first and second gate circuits, the first and second holding circuits and the logic circuit, and confirming that the second holding circuit outputs the second data within a predetermined signal transfer time from when inputting the first data to the first driving circuit; and
the step of supplying by the power supply circuit that the semiconductor device has a second substrate bias voltage lower than the first substrate bias voltage to transistors included in the first and second driving circuits in a case where the second holding circuit does not output the second data within the predetermined signal transfer time.

17. The test program for the semiconductor device according to claim 16, **characterized in that**
the first and second driving circuits are inverter circuits;
the first and second gate circuits are transmission gate circuits; and
the first and second holding circuits include respective one pairs of inverter circuits that are connected to form loops.

18. The test program for the semiconductor device according to claim 17, **characterized in that** the semiconductor device has:
a first latch circuit that includes the first driving circuit, the first gate circuit and the first holding circuit; and
a second latch circuit that includes the second driving circuit, the second gate circuit and the second holding circuit.
